# EUROPEAN PATENT APPLICATION

(11) **EP 4 683 235 A1**
(43) Date of publication of application: **21.01.2026**
(21) Application number: 25726006.7
(22) Date of filing: 27.05.2025
(51) Int. Cl.: H04B 1/50, H04B 1/00, H04B 7/0413, H04B 17/318, H04B 17/336, H05K 1/14

(54) **ELECTRONIC DEVICE AND METHOD FOR TRANSMITTING AND RECEIVING SIGNAL IN ELECTRONIC DEVICE**

(30) Priority: 27.05.2024 KR 20240068452; 16.07.2024 KR 20240093882
(71) Applicant: Samsung Electronics Co., Ltd., Suwon-si, Gyeonggi-do 16677 (KR)
(72) Inventor: MIN, Jungsik, Suwon-si, Gyeonggi-do 16677 (KR); PARK, Sungchul, Suwon-si, Gyeonggi-do 16677 (KR); PARK, Jinseong, Suwon-si, Gyeonggi-do 16677 (KR); SON, Seunghee, Suwon-si, Gyeonggi-do 16677 (KR); LEE, Wonsub, Suwon-si, Gyeonggi-do 16677 (KR); CHOI, Seongkyu, Suwon-si, Gyeonggi-do 16677 (KR); HAN, Sanghyun, Suwon-si, Gyeonggi-do 16677 (KR); HAN, Woong, Suwon-si, Gyeonggi-do 16677 (KR); HEO, Wonhyung, Suwon-si, Gyeonggi-do 16677 (KR)
(74) Representative: Gulde & Partner
(86) International application number: PCT/KR2025/007188
(87) International publication number: WO 2025/249877

(57) **Abstract**

According to various embodiments, an operating method of an electronic device including a first printed circuit board (PCB) including a radio frequency integrated circuit (RFIC), a second PCB including a radio frequency front end (RFFE) circuit connected to the RFIC and at least one antenna therebetween, at least one flexible PCB (FPCB) including a plurality of transmission lines including a first radio frequency (RF) transmission line, a second RF transmission line, and a third RF transmission line, and connected to the first PCB and the second PCB therebetween, and at least one processor may include transmitting transmission (Tx) signals through the first RF transmission line from the first PCB to the second PCB, controlling transmission of first reception (Rx) signals, received via the at least one antenna, through the second RF transmission line from the second PCB to the first PCB, identifying information related to a quality of the first Rx signals transmitted through the second RF transmission line while transmitting the Tx signals through the first RF transmission line, and controlling change of a signal path of the first Rx signals from the second RF transmission line to the third RF transmission line, based on the information related to the quality of the first Rx signals satisfying a first condition.

## Description

### [Technical Field]

Various aspects of the disclosure relate to an electronic device and a method for transmitting and receiving a signal in an electronic device.

### [Background Art]

As portable terminals providing various functions are widely used due to the development of mobile communication technology, efforts are being made to provide a communication system in order to meet the increasing demand for wireless data traffic. For example, to achieve a high data transmission rate, a 5G communication system may provide a service in a higher frequency band (e.g., a 25 to 60 GHz band) in addition to a frequency band used in a 3G communication system and a long-term evolution (LTE) communication system in order to provide a high data transmission speed.

For example, to alleviate the path loss of radio waves and to increase the transmission distance of radio waves in a mmWave band, beamforming, massive multiple-input multiple-output (massive MIMO), full-dimensional MIMO (FD-MIMO), array antenna, analog beamforming, and large-scale antenna techniques are under discussion for implementation in a 5G communication system.

To transmit a signal from an electronic device to a communication network (e.g., a base station), data generated from a processor or a communication processor in the electronic device may be subjected to signal processing via an RF circuit (e.g., a radio frequency integrated circuit (RFIC) or a radio frequency front end (RFFE)) and then transmitted to the outside of the electronic device through at least one antenna. A signal received from the outside through the at least one antenna may be subjected to signal processing via the RF circuit (e.g., the RFFE) and then received by the RFIC.

The above-described information may be provided as related art for the purpose of assisting in understanding the disclosure. No assertion or decision is made as to whether any of the above might be applicable as prior art with regard to the disclosure.

### [Detailed Description]

### [Technical Solution]

Various aspects are related to an electronic device. The electronic device may include a first printed circuit board (PCB) including a radio frequency integrated circuit (RFIC). The electronic device may include a second PCB including a radio frequency front end (RFFE) circuit connected to at least one antenna. The electronic device may include at least one flexible PCB (FPCB) including a plurality of transmission lines including a first radio frequency (RF) transmission line, a second RF transmission line, and a third RF transmission line, and connected to the first PCB and the second PCB therebetween. The electronic device may include memory storing instructions and at least one processor. The instructions, when executed by the at least one processor individually or collectively, may cause the electronic device to transmit transmission (Tx) signals from the first PCB to the second PCB through the first RF transmission line. The instructions, when executed by the at least one processor individually or collectively, may cause the electronic device to control transmission of first reception (Rx) signals, received via the at least one antenna, from the second PCB to the first PCB through the second RF transmission line. The instructions, when executed by the at least one processor individually or collectively, may cause the electronic device to identify information related to a quality of the first Rx signals transmitted through the second RF transmission line while transmitting the Tx signals through the first RF transmission line. The instructions, when executed by the at least one processor individually or collectively, may cause the electronic device to control change of a signal path of the first Rx signals from the second RF transmission line to the third RF transmission line, based on the information related to the quality of the first Rx signals satisfying a first condition.

Various aspects are related to an operating method of an electronic device. The electronic device may include a first printed circuit board (PCB) including a radio frequency integrated circuit (RFIC), a second PCB including a radio frequency front end (RFFE) circuit connected to the RFIC and at least one antenna therebetween, at least one flexible PCB (FPCB) including a plurality of transmission lines including a first radio frequency (RF) transmission line, a second RF transmission line, and a third RF transmission line, and connected to the first PCB and the second PCB therebetween, and at least one processor. The operating method of the electronic device may include transmitting transmission (Tx) signals from the first PCB to the second PCB through the first RF transmission line. The operating method of the electronic device may include controlling transmission of first reception (Rx) signals, received via the at least one antenna, from the second PCB to the first PCB through the second RF transmission line. The operating method of the electronic device may include identifying information related to a quality of the first Rx signals transmitted through the second RF transmission line while transmitting the Tx signals through the first RF transmission line. The operating method of the electronic device may include controlling change of a signal path of the first Rx signals from the second RF transmission line to the third RF transmission line, based on the information related to the quality of the first Rx signals satisfying a first condition.

According to various aspects, a computer-readable storage medium may store at least one instruction which, when executed by a processor of an electronic device individually or collectively, cause the electronic device to perform at least one operation. The at least one operation may include an operation of transmitting transmission (Tx) signals from the first PCB to the second PCB through a first RF transmission line among a plurality of transmission lines disposed on a flexible printed circuit board (PCB) connecting a first PCB including a radio frequency integrated circuit (RFIC) and a second PCB including a radio frequency front end (RFFE) circuit connected to the RFIC and at least one antenna therebetween. The at least one operation may include an operation of controlling transmission of first reception (Rx) signals, received via the at least one antenna, from the second PCB to the first PCB through a second RF transmission line among the plurality of transmission lines. The at least one operation may include an operation of identifying information related to a quality of the first Rx signals transmitted through the second RF transmission line while transmitting the Tx signals through the first RF transmission line. The at least one operation may include an operation of controlling change of a signal path of the first Rx signals from the second RF transmission line to a third RF transmission line among the plurality of transmission lines, based on the information related to the quality of the first Rx signals satisfying a first condition.

Various aspects are related to an electronic device. The electronic device may include a first printed circuit board (PCB) including a radio frequency integrated circuit (RFIC). The electronic device may include a second PCB including a radio frequency front end (RFFE) circuit connected to at least one antenna. The electronic device may include at least one flexible PCB (FPCB) including a plurality of transmission lines including a first RF transmission line, a second RF transmission line, and a third RF transmission line, and connected to the first PCB and the second PCB therebetween. The electronic device may include memory storing instructions and at least one processor. The instructions, when executed by the at least one processor individually or collectively, may cause the electronic device to transmit transmission (Tx) signals from the first PCB to the second PCB through the first RF transmission line. The instructions, when executed by the at least one processor individually or collectively, may cause the electronic device to control transmission of first reception (Rx) signals, received via the at least one antenna, from the second PCB to the first PCB through the second RF transmission line. The instructions, when executed by the at least one processor individually or collectively, may cause the electronic device to identify a magnitude of the Tx signals transmitted through the first RF transmission line while transmitting the Tx signals through the first RF transmission line. The instructions, when executed by the at least one processor individually or collectively, may cause the electronic device to control change of a signal path of the first Rx signals from the second RF transmission line to the third RF transmission line, based on the magnitude of the Tx signals satisfying a first condition.

### [Brief Description of Drawings]

With regard to the description of the drawings, the same or like reference signs may be used to designate the same or like elements.
FIG. 1 is a block diagram of an electronic device in a network environment according to various embodiments;
FIG. 2 is a block diagram of an electronic device for supporting communication via a legacy network and communication via a 5G network according to various embodiments;
FIG. 3A illustrates wireless communication systems providing a network for legacy communication and/or 5G communication according to various embodiments;
FIG. 3B illustrates wireless communication systems providing a network for legacy communication and/or 5G communication according to various embodiments;
FIG. 3C illustrates wireless communication systems providing a network for legacy communication and/or 5G communication according to various embodiments;
FIG. 4A is a block diagram of an electronic device according to various embodiments;
FIG. 4B is a block diagram of an electronic device according to various embodiments;
FIG. 5 illustrates the internal structure of an electronic device according to various embodiments;
FIG. 6 is a block diagram of an electronic device according to various embodiments;
FIG. 7 is a block diagram of an electronic device according to various embodiments;
FIG. 8 is a block diagram of an electronic device according to various embodiments;
FIG. 9 is a flowchart illustrating an operating method of an electronic device according to various embodiments;
FIG. 10 is a flowchart illustrating an operating method of an electronic device according to various embodiments;
FIG. 11 is a block diagram of an electronic device according to various embodiments;
FIG. 12 is a block diagram of an electronic device according to various embodiments;
FIG. 13 is a flowchart illustrating an operating method of an electronic device according to various embodiments;
FIG. 14 is a flowchart illustrating an operating method of an electronic device according to various embodiments;
FIG. 15 is a block diagram of an electronic device according to various embodiments;
FIG. 16 is a flowchart illustrating an operating method of an electronic device according to various embodiments;
FIG. 17A is a block diagram of an electronic device according to various embodiments;
FIG. 17B is a block diagram of an electronic device according to various embodiments; and
FIG. 18 is a block diagram of an electronic device according to various embodiments.

### [Mode for Carrying out the Invention]

Hereinafter, embodiments of the disclosure will be described in detail with reference to the drawings so that those skilled in the art to which the disclosure pertains can easily implement the disclosure. However, the disclosure may be implemented in various forms and is not limited to embodiments set forth herein. With regard to the description of the drawings, the same or like reference signs may be used to designate the same or like elements. Also, in the drawings and the relevant descriptions, description of well-known functions and configurations may be omitted for the sake of clarity and brevity.

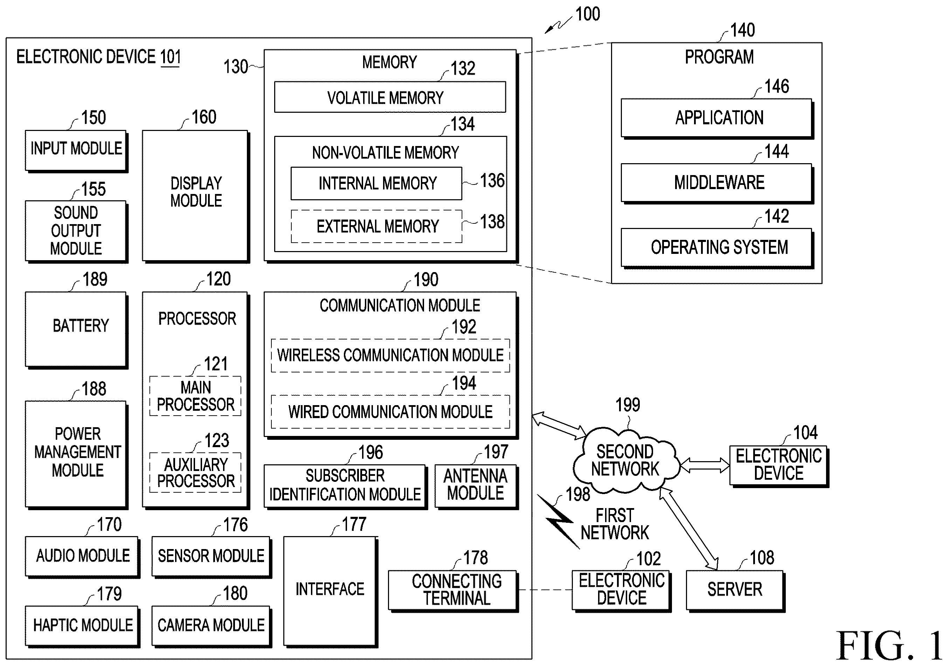

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semisupervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

In the following description, configurations that can be understood through the preceding embodiments may be provided with the same reference numerals in the drawings or provided with no reference numerals, and detailed descriptions thereof may also be omitted. An electronic device according to an embodiment disclosed herein may be implemented by selective combinations of different embodiments, and a configuration of one embodiment may be replaced by a configuration of another embodiment. For example, it should be noted that the disclosure is limited by a specific drawing or embodiment.

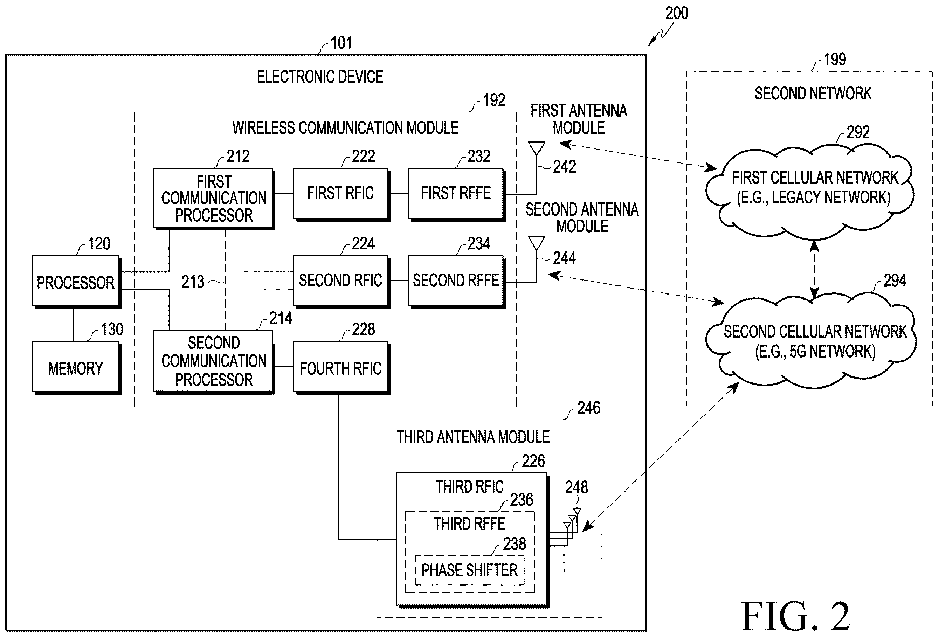

FIG. 2 is a block diagram 200 of an electronic device 101 for supporting communication via a legacy network and communication via a 5G network according to various embodiments. Referring to FIG. 2, the electronic device 101 may include a first communication processor 212, a second communication processor 214, a first radio frequency integrated circuit (RFIC) 222, a second RFIC 224, a third RFIC 226, a fourth RFIC 228, a first radio frequency front end (RFFE) 232, a second RFFE 234, a first antenna module 242, a second antenna module 244, a third antenna module 246, and antennas 248. The electronic device 101 may (e.g., additionally) include a processor 120 and memory 130. A second network 199 may include a first cellular network 292 and a second cellular network 294. According to various embodiment, the electronic device 101 may (e.g., additionally) include at least one of the components illustrated in FIG. 1, and the second network 199 may (e.g., additionally) include at least one different network. According to an embodiment, the first communication processor 212, the second communication processor 214, the first RFIC 222, the second RFIC 224, the fourth RFIC 228, the first RFFE 232, and the second RFFE 234 may form at least part of a wireless communication module 192. According to another embodiment, the fourth RFIC 228 may be omitted or may be included as part of the third RFIC 226.

The first communication processor 212 may establish a communication channel in a band to be used for wireless communication with the first cellular network 292 and may support communication via a legacy network through the established communication channel. According to various embodiments, the first cellular network may be a legacy network including a secondgeneration (2G), 3G, 4G, or long-term evolution (LTE) network. The second communication processor 214 may establish a communication channel corresponding to a specified band (e.g., about 6 GHz to about 60 GHz) in a band to be used for wireless communication with the second cellular network 294 and may support communication via a 5G network through the established communication channel. According to various embodiments, the second cellular network 294 may be a 5G network defined by the 3GPP. In addition, according to an embodiment, the first communication processor 212 or the second communication processor 214 may establish a communication channel corresponding to a different specified band (e.g., about 6 GHz or lower) in the band to be used for wireless communication with the second cellular network 294 and may support communication via a 5G network through the established communication channel. According to various embodiments, the first communication processor 212 may support a band corresponding to about 410 MHz to 7.125 GHz, and the second communication processor 214 may support a band corresponding to about 24.25 GHz to 52.6 GHz.

The first communication processor 212 may transmit and receive data to and from the second communication processor 214. For example, data classified to be transmitted through the second cellular network 294 may be changed to be transmitted through the first cellular network 292. In this case, the first communication processor 212 may receive the data to be transmitted from the second communication processor 214. For example, the first communication processor 212 may transmit and receive data to and from the second communication processor 214 through an inter-processor interface 213. The inter-processor interface 213 may be configured, for example, as a universal asynchronous receiver/transmitter (UART, e.g., high-speed UART (HS-UART)) or peripheral component interconnect express (PCIe) bus interface but is not limited in type. Alternatively, the first communication processor 212 and the second communication processor 214 may exchange control information and packet data information, for example, using a shared memory. The first communication processor 212 may exchange various types of information, such as sensing information, output strength information, and resource block (RB) allocation information, with the second communication processor 214.

The first communication processor 212 may not be directly connected to the second communication processor 214 depending on a configuration. In this case, the first communication processor 212 may transmit and receive data to and from the second communication processor 214 via a processor 120 (e.g., an application processor). For example, the first communication processor 212 and the second communication processor 214 may transmit and receive data to and from each other through the processor 120 (e.g., the application processor) and an HS-UART interface or a PCIe interface, but the type of an interface is not limited. Alternatively, the first communication processor 212 and the second communication processor 214 may exchange control information and packet data information using the processor 120 (e.g., the application processor) and a shared memory.

According to an embodiment, the first communication processor 212 and the second communication processor 214 may be configured in a single chip or a single package. According to various embodiments, the first communication processor 212 and/or the second communication processor 214 may be configured along with the processor 120, a coprocessor 123, or a communication module 190 in a single chip or a single package. For example, an integrated communication processor in which the first communication processor 212 and the second communication processor 214 are integrated may support functions for communication with both the first cellular network 292 and the second cellular network 294.

In transmission (e.g., in a transmission operation of the electronic device 101), the first RFIC 222 may convert a baseband signal generated by the first communication processor 212 into a radio frequency (RF) signal of about 700 MHz to about 3 GHz used for the first cellular network 292 (e.g., a legacy network). In reception (e.g., in a reception operation of the electronic device 101), an RF signal may be obtained from the first network 292 (e.g., the legacy network) through an antenna (e.g., the first antenna module 242) and may be preprocessed by an RFFE (e.g., the first RFFE 232). The first RFIC 222 may convert the preprocessed RF signal into a baseband signal to be processed by the first communication processor 212.

In transmission (e.g., in a transmission operation of the electronic device 101), the second RFIC 224 may convert a baseband signal generated by the first communication processor 212 or the second communication processor 214 into an RF signal (hereinafter, "5G sub-6 RF signal") in a sub-6 band (e.g., about 6 GHz or lower) used for the second cellular network 294 (e.g., a 5G network). In reception (e.g., in a reception operation of the electronic device 101), a 5G sub-6 RF signal may be obtained from the second cellular network 294 (e.g., the 5G network) through an antenna (e.g., the second antenna module 244) and may be preprocessed by an RFFE (e.g., the second RFFE 234). The second RFIC 224 may convert the preprocessed 5G sub-6 RF signal into a baseband signal to be processed by a corresponding communication processor of the first communication processor 212 or the second communication processor 214.

The third RFIC 226 may convert a baseband signal generated by the second communication processor 214 into an RF signal (hereinafter, "5G above-6 RF signal") in a 5G above-6 band (e.g., about 6 GHz to about 60 GHz) used for the second cellular network 294 (e.g., the 5G network). In reception (e.g., in a reception operation of the electronic device 101), a 5G above-6 RF signal may be obtained from the second cellular network 294 (e.g., the 5G network) through an antenna (e.g., an antenna 248) and may be preprocessed by the third RFFE 236. The third RFIC 226 may convert the preprocessed 5G above-6 RF signal into a baseband signal to be processed by the second communication processor 214. According to an embodiment, the third RFFE 236 may be configured as part of the third RFIC 226.

According to an embodiment, the electronic device 101 may include a fourth RFIC 228 separately from the third RFIC 226 or as at least part of the third RFIC 226. In this case, the fourth RFIC 228 may convert a baseband signal generated by the second communication processor 214 into an RF signal (hereinafter, "IF signal") in an intermediate frequency band (e.g., about 9 GHz to about 11 GHz) and may transmit the IF signal to the third RFIC 226. The third RFIC 226 may convert the IF signal into a 5G above-6 RF signal. In reception (e.g., in a reception operation of the electronic device 101), a 5G above-6 RF signal may be received from the second cellular network 294 (e.g., the 5G network) through an antenna (e.g., the antenna 248) and may be converted into an IF signal by the third RFIC 226. The fourth RFIC 228 may convert the IF signal into a baseband signal to be processed by the second communication processor 214. The RFICs 222, 224, 226, and 228 may correspond to an RF transceiver. According to an embodiment, at least part of the RF transceiver and/or a peripheral circuit of the RF transceiver may perform a function corresponding to the RFICs 222, 224, 226, and 228.

According to an embodiment, the first RFIC 222 and the second RFIC 224 may be configured as at least part of a single chip or a single package. According to various embodiments, when the first RFIC 222 and the second RFIC 224 are configured as a single chip or a single package in FIG. 2, the first RFIC 222 and the second RFIC 224 may be configured as an integrated RFIC. In this case, the integrated RFIC may be connected to the first RFFE 232 and the second RFFE 234, and thus the integrated RFIC may convert a baseband signal into a signal in a band supported by the first RFFE 232 and/or the second RFFE 234, and transmit the converted signal to one of the first RFFE 232 and the second RFFE 234. According to an embodiment, the first RFFE 232 and the second RFFE 234 may be configured as at least part of a single chip or a single package. According to an embodiment, at least one of the first antenna module 242 or the second antenna module 244 may be omitted or may be combined with a different antenna module to process corresponding RF signals in a plurality of bands.

According to an embodiment, the third RFIC 226 and the antenna 248 may be disposed on the same substrate to form a third antenna module 246. For example, the wireless communication module 192 or the processor 120 may be disposed on a first substrate (e.g., a main PCB). In this case, the third RFIC 226 may be disposed in a portion (e.g., a lower surface) of a second substrate (e.g., a sub-PCB) separate from the first substrate, and the antenna 248 may be disposed in another portion (e.g., an upper surface), thereby forming the third antenna module 246. The third RFIC 226 and the antenna 248 may be disposed on the same substrate, thereby reducing the length of a transmission line therebetween, which may reduce loss (e.g., attenuation) of, for example, a signal in a high-frequency band (e.g., about 6 GHz to about 60 GHz) used for communication via a 5G network due to the transmission line. Accordingly, the electronic device 101 may improve the quality or speed of communication with the second network 294 (e.g., the 5G network).

According to an embodiment, the antenna 248 may be configured as an antenna array including a plurality of antenna elements available for beamforming. In this case, the third RFIC 226 may include, for example, a plurality of phase shifters 238 corresponding to the plurality of antenna elements as part of the third RFFE 236. In transmission (e.g., in a transmission operation of the electronic device 101), each of the plurality of phase shifters 238 may convert the phase of a 5G above-6 RF signal to be transmitted to an external device (e.g., a base station of the 5G network) of the electronic device 101 through a corresponding antenna element. In reception (e.g., in a reception operation of the electronic device 101), each of the plurality of phase shifters 238 may convert the phase of a 5G above-6 RF signal received from the outside through a corresponding antenna element into the same phase or substantially the same phase. This enables transmission or reception through beamforming between the electronic device 101 and the outside.

The second cellular network 294 (e.g., the 5G network) may operate independently of the first cellular network 292 (e.g., the legacy network) (e.g., stand-alone (SA) mode) or may be connected to operate (e.g., non-stand-alone (NSA) mode). For example, the 5G network may have only an access network (e.g., a 5G radio access network (RAN) or a next-generation RAN (NG RAN)) and may not have a core network (e.g., a next-generation core (NGC)). In this case, after accessing the access network of the 5G network, the electronic device 101 may access an external network (e.g., the Internet) under control of a core network (e.g., an evolved packed core (EPC)) of the legacy network. Protocol information (e.g., LTE protocol information) for communication with the legacy network or protocol information (e.g., new radio (NR) protocol information) for communication with the 5G network may be stored in memory 230 and may be accessed by a different component (e.g., the processor 120, the first communication processor 212, or the second communication processor 214).

It is noted that various details of the electronic device 101 are described hereinbased on specific components included in the electronic device 101. However, the electronic device may include only some of the described components or one or more additional components to properly implement the desired functions to be provided by the electronic device and/or as desired for operating the electronic device, as described herein.

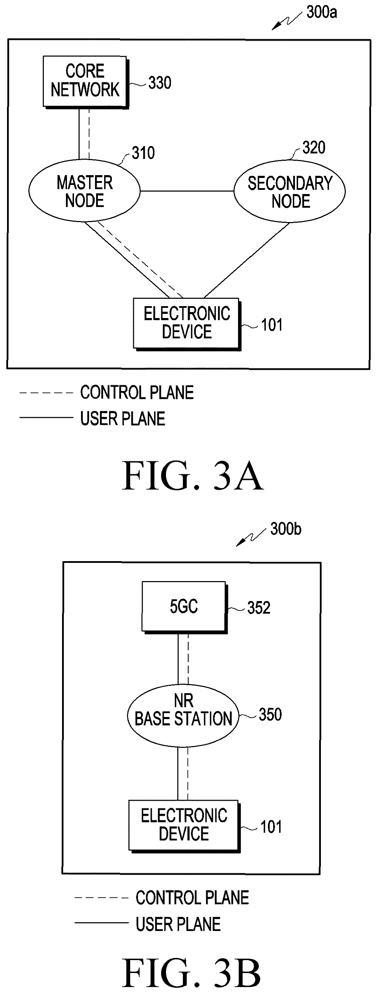

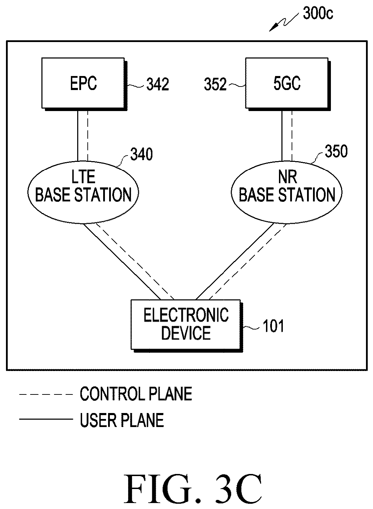

FIG. 3A, FIG. 3B, and FIG. 3C illustrate wireless communication systems providing a network for legacy communication and/or 5G communication according to various embodiments. Referring to FIG. 3A, FIG. 3B, and FIG. 3C, network environments 300a to 300c may include at least one of a legacy network and a 5G network. The legacy network may include, for example, a 4G or LTE base station 340 (e.g., eNodeB (eNB)) according to a 3GPP standard supporting radio access with an electronic device 101 and an evolved packet core (EPC) 342 which manages 4G communication. The 5G network may include, for example, a new radio (NR) base station 350 (e.g., gNodeB (gNB)) supporting radio access with the electronic device 101 and a fifth-generation core (5GC) 352 which manages 5G communication of the electronic device 101.

According to various embodiments, the electronic device 101 may transmit and receive a control message and user data through legacy communication and/or 5G communication. The control message may include, for example, a message associated with at least one of security control, bearer setup, authentication, registration, or mobility management of the electronic device 101. The user data may refer to, for example, user data other than a control message transmitted and received between the electronic device 101 and a core network 330 (e.g., the EPC 342).

Referring to FIG. 3A, FIG. 3B, and FIG. 3C, the electronic device 101 according to an embodiment may transmit or receive at least one of a control message or user data to or from at least part of the 5G network (e.g., the NR base station 350 and the 5GC 352) using at least part of the legacy network (e.g., the LTE base station 340 and the EPC 342).

According to various embodiments, a network environment 300a may include a network environment which provides wireless communication dual connectivity (DC) to the LTE base station 340 and the NR base station 350 and enables transmission and reception of a control message to and from the electronic device 101 through one core network 330 of the EPC 342 or the 5GC 352.

According to various embodiments, in a DC environment, one of the LTE base station 340 or the NR base station 350 may operate as a master node (MN) 310 and the other thereof may operate as a secondary node (SN) 320. The MN 310 may be connected to the core network 330 to transmit and receive a control message. The MN 310 and the SN 320 may be connected through a network interface to transmit and receive a message related to radio resource (e.g., communication channel) management to and from each other.

According to various embodiments, the MN 310 may include the LTE base station 340, the SN 320 may include the NR base station 350, and the core network 330 may include the EPC 342. For example, a control message may be transmitted and received through the LTE base station 340 and the EPC 342, and user data may be transmitted and received through at least one of the LTE base station 340 and the NR base station 350.

According to various embodiments, the MN 310 may include the NR base station 350, the SN 320 may include the LTE base station 340, and the core network 330 may include the 5GC 352. For example, a control message may be transmitted and received through the NR base station 350 and the 5GC 352, and user data may be transmitted and received through at least one of the LTE base station 340 and the NR base station 350.

Referring to FIG. 3B, according to various embodiments, the 5G network may include the NR base station 350 and the 5GC 352 and may independently transmit and receive a control message and user data to and from the electronic device 101.

Referring to FIG. 3C, the legacy network and the 5G network according to various embodiments may independently provide data transmission and reception. For example, the electronic device 101 and the EPC 342 may transmit and receive a control message and user data through the LTE base station 340. In another example, the electronic device 101 and the 5GC 352 may transmit and receive a control message and user data through the NR base station 350.

According to various embodiments, the electronic device 101 may be registered in at least one of the EPC 342 or the 5GC 352 to transmit and receive a control message.

According to various embodiments, the EPC 342 or the 5GC 352 may interwork to manage communication of the electronic device 101. For example, movement information about the electronic device 101 may be transmitted and received through an interface between the EPC 342 and the 5GC 352.

As described above, dual connectivity through the LTE base station 340 and the NR base station 350 may be referred to as E-UTRA new radio dual connectivity (EN-DC).

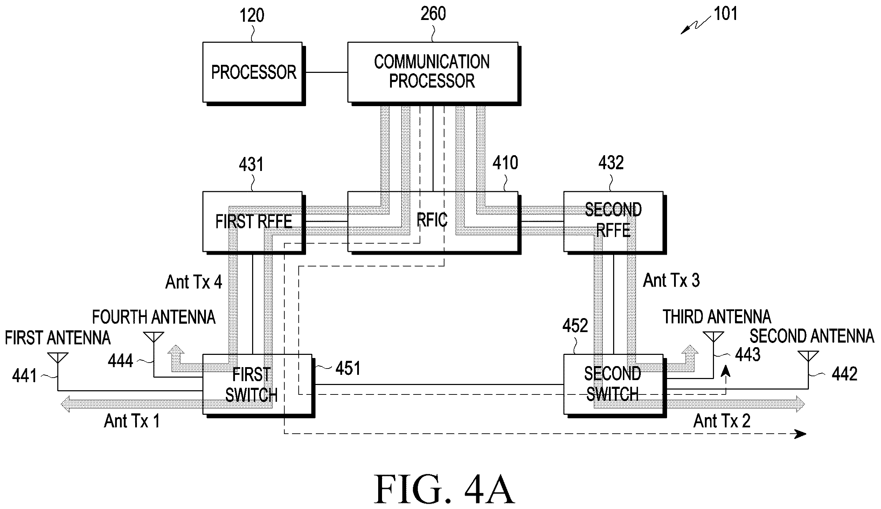

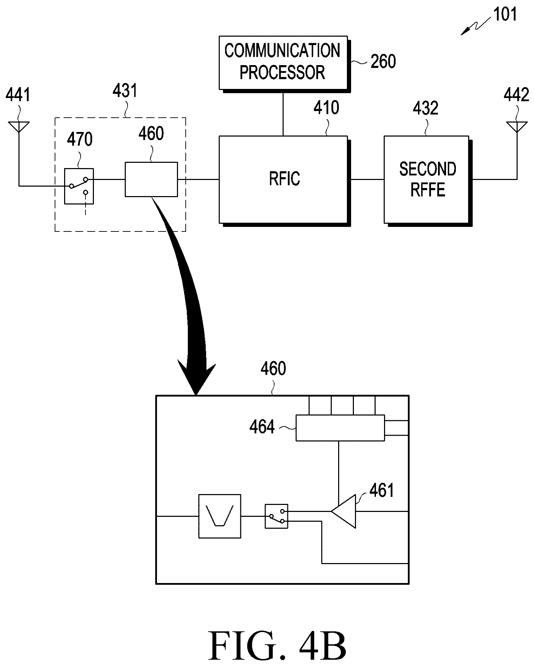

Hereinafter, the structure of an electronic device (e.g., electronic device 101) according to various embodiments will be described in detail with reference to FIG. 4A and FIG. 4B. Although each drawing of the following embodiments shows that one communication processor 260 and one RFIC 410 are connected to a plurality of RFFEs 431 and 432, the following various embodiments are not limited thereto. For example, in the following various embodiments, as illustrated in FIG. 2, a plurality of communication processors 212 and 214 and/or a plurality of RFICs 222, 224, 226, and 228 may be connected to a plurality of RFFEs 232, 234, and 236.

FIG. 4A is a block diagram of an electronic device according to various embodiments.

Referring to FIG. 4A, the electronic device (e.g., the electronic device 101 as illustrated exemplarily inFIG. 1and/or FIG. 2) according to various embodiments may include a processor 120, a communication processor 260, an RFIC 410, a first RFFE 431, a second RFFE 432, a first antenna 441, a second antenna 442, a third antenna 443, a fourth antenna 444, a first switch 451, or a second switch 452. For example, the first RFFE 431 may be disposed in an upper position in a housing of the electronic device 101, and the second RFFE 432 may be disposed in a lower position than the first RFFE 431 in the housing of the electronic device 101, but various embodiments of the disclosure are not limited to the foregoing positions.

According to various embodiments, in transmission (e.g., in a transmission operation of the electronic device 101), the RFIC 410 may convert a baseband signal generated by the communication processor 260 into a radio frequency (RF) signal used for a first communication network or a second communication network. For example, the RFIC 410 may transmit an RF signal used for the first communication network to the first antenna 441 or the fourth antenna 444 through the first RFFE 431 and the first switch 451. The RFIC 410 may transmit an RF signal used for the first communication network or the second communication network to the second antenna 442 or the third antenna 443 through the second RFFE 432 and the second switch 452. According to various embodiments, the RFIC 410 may transmit an RF signal corresponding to the first communication network (e.g., NR) to the first antenna 441 or the fourth antenna 444 through the first RFFE 431 and may transmit an RF signal corresponding to the second communication network (e.g., LTE) to the second antenna 442 or the third antenna 443 through the second RFFE 432. According to another embodiment, the RFIC 410 may operate as a multi-input multi-output (MIMO) antenna by transmitting an RF signal corresponding to the first communication network (e.g., NR) or the second communication network (e.g., LTE) to the first antenna 441 or the fourth antenna 444 through the first RFFE 431 and transmitting the same RF signal corresponding to the first communication network (e.g., NR) or the second communication network (e.g., LTE) to the second antenna 442 or the third antenna 443 through the second RFFE 432.

According to various embodiments, a transmission path for transmission from the RFIC 410 to the first antenna 441 via the first RFFE 431 and the first switch 451 may be referred to as a "first antenna transmission path (Ant Tx 1)". A transmission path for transmission from the RFIC 410 to the fourth antenna 444 via the first RFFE 431 and the first switch 451 may be referred to as a "fourth antenna transmission path (Ant Tx 4)".

According to various embodiments, in transmission (e.g., in a transmission operation of the electronic device 101), the RFIC 410 may convert a baseband signal generated by the communication processor 260 into a radio frequency (RF) signal used for the first communication network or the second communication network. For example, the RFIC 410 may transmit an RF signal used for the first communication network or the second communication network to the second antenna 442 or the third antenna 443 through the second RFFE 432 and the second switch 452.

According to various embodiments, a transmission path for transmission from the RFIC 410 to the second antenna 442 via the second RFFE 432 and the second switch 452 may be referred to as a "second antenna transmission path (Ant Tx 2)". A transmission path for transmission from the RFIC 410 to the third antenna 443 via the second RFFE 432 and the second switch 452 may be referred to as a "third antenna transmission path (Ant Tx 3)".

According to various embodiments, in reception (e.g., in a reception operation of the electronic device 101), an RF signal may be received from the first communication network through the first antenna 441 or the fourth antenna 444, and the received RF signal may be transmitted to the communication processor 260 through at least one RFIC (e.g., the RFIC 410). Further, an RF signal may be received from the first communication network or the second communication network through the second antenna 442 or the third antenna 443, and the received RF signal may be transmitted to the communication processor 260 via at least one RFIC (e.g., the RFIC 410).

According to various embodiments, the first communication network and the second communication network may be different communication networks. For example, the first communication network may be a 5G network, and the second communication network may be a legacy network (e.g., an LTE network). When the first communication network is a 5G network, the first RFFE 431 may be designed to be suitable to process a signal corresponding to the 5G network, and the second RFFE 432 may be designed to be suitable to process a signal corresponding to the legacy network. According to various embodiments, the frequency band of a signal transmitted through the first RFFE 431 and the frequency band of a signal transmitted through the second RFFE 432 may be the same, similar, or different. According to various embodiments, when the electronic device transmits a signal through at least one of the first antenna 441 and the fourth antenna 444 via the first RFFE 431 and the first switch 451 and transmits a reference signal (e.g., a sounding reference signal (SRS)) through the first antenna 441 and the fourth antenna 444, one transmitting antenna (Tx) and two receiving antennas (Rx) are used, which may be referred to as "1T2R". According to various embodiments, when the electronic device transmits a signal through at least one of the second antenna 442 and the third antenna 443 via the second RFFE 432 and the second switch 452 and transmits a reference signal (e.g., an SRS) through the second antenna 442 and the third antenna 443, one transmitting antenna (Tx) and two receiving antennas (Rx) are used, which may be referred to as "1T2R".

According to various embodiments, when the electronic device transmits and receives data simultaneously through the first RFFE 431 and the second RFFE 432, two transmitting antennas (Tx) and four receiving antennas (Rx) are used, which may be referred to as "2T4R". The electronic device illustrated in FIG. 4A may operate as 1T2R or 2T4R according to various embodiments and may thus be referred to as an electronic device supporting "1T2R/2T4R".

According to various embodiments, in transmission (e.g., in a transmission operation of the electronic device 101), the RFIC 410 may convert a baseband signal generated by the communication processor 260 into a radio frequency (RF) signal used for the first communication network or the second communication network. For example, the RFIC 410 may transmit an RF signal used for the first communication network to the first antenna 441 or the fourth antenna 444 through the first RFFE 431 and the first switch 451. Further, the RFIC 410 may transmit the RF signal used for the first communication network to the second antenna 442 or the third antenna 443 through the first RFFE 431, the first switch 451, and the second switch 452.

According to various embodiments, the RFIC 410 may transmit an RF signal corresponding to the first communication network (e.g., NR) to the first antenna 441 or the fourth antenna 444 through the first RFFE 431 and may transmit an RF signal corresponding to the second communication network (e.g., LTE) to the second antenna 442 or the third antenna 443 through the second RFFE 432. According to various embodiments, the RFIC 410 may operate as a multi-input multi-output (MIMO) antenna by transmitting an RF signal corresponding to the first communication network (e.g., NR) or the second communication network (e.g., LTE) to the first antenna 441 or the fourth antenna 444 through the first RFFE 431 and the first switch 451 and transmitting the RF signal to the second antenna 442 or the third antenna 443 through the first RFFE 431, the first switch 451, and the second switch 452. According to various embodiments, a transmission path for transmission from the RFIC 410 to the first antenna 441 via the first RFFE 431 and the first switch 451 may be referred to as a "first antenna transmission path (Ant Tx 1)". A transmission path for transmission from the RFIC 410 to the fourth antenna 444 via the first RFFE 431 and the first switch 451 may be referred to as a "fourth antenna transmission path (Ant Tx 4)". A transmission path for transmission from the RFIC 410 to the second antenna 442 via the first RFFE 431, the first switch 451, and the second switch 452 may be referred to as a "second antenna transmission path (Ant Tx 2)". A transmission path for transmission from the RFIC 410 to the third antenna 443 via the first RFFE 431, the first switch 451, and the second switch 452 may be referred to as a "third antenna transmission path (Ant Tx 3)".

FIG. 4B is a detailed block diagram of an electronic device according to various embodiments. Referring to FIG. 4B, the electronic device (e.g., the electronic device 101 as illustrated exemplarily in FIG. 1) according to various embodiments may include a communication processor 260, an RFIC 410, a first RFFE 431, a first antenna 441, a second RFFE 432, and a second antenna 442.

According to various embodiments, the first RFFE 431 may (e.g., additionally) include additional components different from the second RFFE 432 to process a signal according to a characteristic of a 5G network or to support a multi-band. For example, the first RFFE 431 may include a front end module (FEM) 460 and a first single pole double throw (SPDT) switch 470.

According to various embodiments, the FEM 460 may include an amplifier (e.g., a power amplifier (PA) 461 and an envelope tracking IC (PA ET IC) 464. According to various embodiments, as illustrated in FIG. 4B, the PA ET IC 464 may be included in the FEM 460 or may be connected to the FEM 460 outside the FEM 460. The PA ET IC 464 may control Vcc of the PA 461 according to control of the communication processor 260 or the RFIC 410. The PA ET IC 464 may operate in a plurality of modes (e.g., an envelope tracking (ET) mode, an average power tracking (APT) mode, and a maximum power mode (e.g., APT full bias or battery direct)) according to control of the communication processor 260 or the RFIC 410.

According to an embodiment, in the following description, the first RFFE 431 and/or the second RFFE 432 may be referred to as an RF circuit. According to an embodiment, the RF circuit may include an amplifier (e.g., a power amplifier (PA)), band-pass filters (BPF), a coupler, a switching circuit (e.g., a switch box or an antenna switch module (ASM)), or a low-noise amplifier (LNA). According to an embodiment, the RF circuit may be referred to as an RFFE, a front end module (FEM), a power amplifier module (PAM), a power amplifier module with an integrated duplexer (PAMiD), an LNA PAMiD (LPAMiD), or a front end module with an integrated duplexer (FEMid) depending on a function or an included component, but is not limited thereto.

According to an embodiment, as illustrated in FIG. 4B, the power amplifier 461 and the switch 470 may be included in a single semiconductor chip or integrated circuit forming the RF circuit (e.g., the first RFFE 431). According to an embodiment, the switch 470 may be configured as a separate module outside the RF circuit. According to an embodiment, as described above, the RF circuit may be configured as a semiconductor chip or integrated circuit integrated with the RF IC 410. For example, the amplifier 461 and/or the switch 470 included in the RF circuit may be configured as an integrated semiconductor chip or an integrated circuit integrated with the RFIC 410 described above.

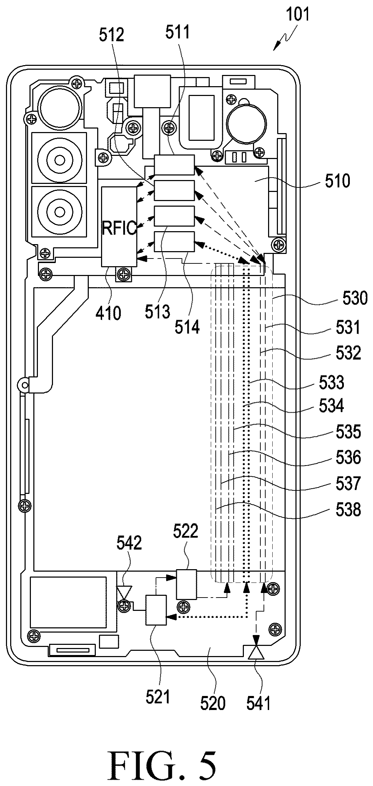

FIG. 5 illustrates an example of an internal structure of an electronic device (e.g., of electronic device 101 as described herein) according to various embodiments.

Referring to FIG. 5, according to an embodiment, the electronic device 101 may include at least one printed circuit board (PCB). For example, the electronic device 101 may include a first PCB 510 and a second PCB 520. The first PCB 510 may be referred to as a main PCB, and the second PCB 520 may be referred to as a sub-PCB, but the disclosure is not limited to the above terms. For example, the second PCB 520 may be referred to as a main PCB, and the first PCB 510 may be referred to as a sub-PCB. Although FIG. 5 illustrates a bar-type electronic device, the electronic device 101 according to various embodiments may include electronic devices of a form factor including a plurality of housings. For example, the electronic device 101 may include a foldable electronic device, a slidable electronic device, or a rollable electronic device including a plurality of housings. According to an embodiment, a first PCB 510 may be disposed in a first housing among a plurality of housings included in the electronic device 101, and a second PCB 520 may be disposed in a second housing among the plurality of housings included in the electronic device 101. According to an embodiment, the first PCB 510 and the second PCB 520 may be included respectively in the first housing and the second housing.

According to an embodiment, the first PCB 510 may include at least one RFIC 410. The first PCB 510 may include at least one RFFE (e.g., the RFFEs 431 and 432 as illustrated exemplarily in FIG. 4A and/or FIG. 4B). According to an embodiment, the first PCB 510 may include at least one power amplifier module (PAM) 511, 512, 513, and 514 including at least one power amplifier (PA) as the at least one RFFE. The at least one PAM 511, 512, 513, and 514 included in the first PCB 510 may amplify an RF signal to be transmitted from the RFIC 410 to the outside of the electronic device 101. For example, the first PCB 510 may include a first PAM 511, a second PAM 512, a third PAM 513, and/or a fourth PAM 514. The first PAM 511 may correspond to a module for amplifying an SRS in an EN-DC operation.

According to an embodiment, the electronic device 101 may amplify an SRS through the at least one PAM 511, 512, 513, and 514 (e.g., the first RFFE 431 or the second RFFE 432 as illustrated exemplarily in FIG. 4A) and may transmit the amplified SRS via a plurality of antennas 541 and 542 (e.g., the first antenna 441, the second antenna 442, the third antenna 443, and the fourth antenna 444 as illustrated exemplarily in FIG. 4A). The SRS transmitted through each antenna of the electronic device 101 may be received through an antenna of a base station (e.g., a gNB). The SRS is a signal transmitted to identify the state of an uplink channel used to transmit a signal from the electronic device 101 to the base station, and the base station receiving the SRS may identify the state of the channel with the electronic device 101 and may report the state to the electronic device 101. The SRS may be for identifying the state of a downlink channel used to transmit a signal from the base station to the electronic device 101, for example, in a MIMO environment.

According to various embodiments, to transmit the SRS, a first antenna (e.g., the first antenna 441) connected to a main PCB (e.g., the first PCB 510) and disposed in an upper part of the electronic device 101 and a second antenna (e.g., the second antenna 442) connected to a sub-PCB (e.g., the second PCB 520) and disposed in a lower part of the electronic device 101 may be used together. The first antenna and the second antenna may each be an antenna group including one antenna element or a plurality of antenna elements (e.g., emitters or grounds). When an SRS is not transmitted, at least one transmission line used for receiving data among transmission lines disposed on an FPCB-type RF cable (FRC) (e.g., FPCB 530) may be used as some signal paths for transmitting an SRS. An SRS path connected to the sub-PCB (e.g., the second PCB 520) via the FRC may be relatively longer and more vulnerable to surrounding interference than an SRS path to the main PCB (e.g., the first PCB 510). Accordingly, compared to an SRS transmitted to the first antenna on the main PCB (e.g., the first PCB 510), in an SRS transmitted to the second antenna via the sub-PCB (e.g., the second PCB 520), an offset value may be added to the strength of power. When the SRS is transmitted through the FRC with a power level increased by adding the offset value, transmission lines on the FRC for LTE data signals being received through an adjacent RF reception path may be changed to or selected from one of a plurality of signal combinations, based on the reception strength/quality (e.g., SINR) of at least one LTE data signal (Rx) or the transmission signal strength of at least one SRS. According to various embodiments, an SRS may be transmitted simultaneously through two or more wires (lines) in the FRC. When an LTE data signal is transmitted simultaneously through transmission lines adjacent to the two or more wires transmitting the SRS, the magnitude or quality of the LTE data signal may be affected.

According to various embodiments, the base station may receive the SRS transmitted from the electronic device 101 and may perform channel estimation for each antenna (e.g., the first antenna 441, the second antenna 442, the third antenna 443, and the fourth antenna 444 as illustrated exemplarily in FIG. 4A) of the electronic device 101 from the received SRS. The base station may transmit a beamformed signal to each antenna (e.g., the first antenna 441, the second antenna 442, the third antenna 443, and the fourth antenna 444 as illustrated exemplarily in FIG. 4A) of the electronic device 101, based on the channel estimation.

The second PAM 512 may correspond to an LNA power amplifier module with an integrated duplexer (PAMiD) (LPAMiD). The third PAM 513 may correspond to a low-band (LB) PAMiD for amplifying a low-band signal. The fourth PAM 514 may correspond to a PAM for amplifying an ultra-high-band (UHB) (e.g., an N78 band) signal. Although FIG. 5 shows four PAMs, the number of PAMs is not limited thereto, and three or fewer or five or more PAMs may be included. Further, each of the PAMs 511, 512, 513, 514 is not limited to the foregoing purposes.

According to an embodiment, the second PCB 520 may include at least one RFFE 522 (e.g., the RFFEs 431 and 432 as illustrated exemplarily in FIG. 4A or FIG. 4B). For example, the second PCB 520 may include an LNA FEM (LFEM) as an example of the RFFE 522. The RFFE 522 (e.g., the LFEM) may amplify an RF signal, received from the outside of the electronic device 101 through at least one antenna, through a low-noise amplifier (LNA). According to an embodiment, the second PCB 520 may (e.g., additionally) include a diplexer 521.

According to an embodiment, the electronic device 101 may include at least one flexible PCB (FPCB) 530 between the first PCB 510 and the second PCB 520. For example, the electronic device 101 may include a first FPCB (e.g., the FPCB 530) for transmitting an RF signal between the first PCB 510 and the second PCB 520 and a second FPCB (not shown) for transmitting a digital signal other than the RF signal. The first FPCB (e.g., the FPCB 530) and an additional second FPCB (not shown) may each be configured to include a plurality of circuit layers. Although the at least one FPCB 530 is connected to the first PCB 510 and the second PCB 520 therebetween in the electronic device 101 illustrated in FIG. 5, embodiments of the disclosure may also be applied to a transmission line (e.g., a wiring connection on the PCB) between the RFIC 410 and the RFFE 432 disposed on the same PCB. The embodiments of the disclosure may also be applied to a transmission line between other RF elements in addition to that between the RFIC 410 and the RFFE 432 or various types of signal paths between other digital elements. The embodiments of the disclosure may be understood to be applicable to any one or more transmission lines between RF elements, e.g., to a transmission line between an RFIC and an RFFE of an electronic communication device,and/or to various other types of signal paths between RF elements (e.g., between digital elements) of an electronic device.

According to an embodiment, the at least one FPCB 530 may include a plurality of transmission lines 531, 532, 533, 534, 535, 536, 537, and 538. For example, the plurality of transmission lines may be disposed in the same circuit layer among the plurality of circuit layers included in the FPCB 530, or some thereof may be disposed in different circuit layers. Although FIG. 5 shows that the at least one FPCB 530 includes eight transmission lines, the number of transmission lines is not limited thereto, and seven or fewer or nine or more transmission lines may be included. For example, the at least one FPCB 530 may transmit and receive an RF signal through each of the plurality of transmission lines. For example, an RF signal transmitted from the first PCB 510 to the at least one FPCB 530 may be transmitted to the second PCB 520 via at least one transmission line included in the at least one FPCB 530. An RF signal transmitted from the second PCB 520 to the at least one FPCB 530 may be transmitted to the first PCB 510 via at least one transmission line included in the at least one FPCB 530. The RF signal transmitted from the first PCB 510 to the second PCB 520 via the at least one transmission line included in the FPCB 530 may correspond to a transmission signal (Tx signal) (e.g., an uplink signal) transmitted from the electronic device 101 to a communication network (e.g., a base station). The RF signal transmitted from the second PCB 530 to the first PCB 510 through the at least one transmission line included in the FPCB 530 may correspond to a reception signal (Rx signal) (e.g., a downlink signal) transmitted from the communication network (e.g., the base station) and received through an antenna of the electronic device 101.

According to an embodiment, a first transmission line 531 and a second transmission line 532 included in the FPCB 530 may be used for transmitting a transmission signal (Tx signal) (e.g., transmission from the first PCB 510 to the second PCB 520) or for transmitting a reception signal (Rx signal) (e.g., transmission from the second PCB 520 to the first PCB 510). For example, an RF signal generated in the RFIC 410 may be amplified through at least one of the first PAM 511, the second PAM 512, or the third PAM 513 and then transmitted to the second PCB 520 through at least one of the first transmission line 531 or the second transmission line 532. The RF signal transmitted to the second PCB 520 through at least one of the first transmission line 531 or the second transmission line 532 may be transmitted to the outside of the electronic device 101 (e.g., the base station) through the first antenna 541. The RF signal transmitted through at least one of the first transmission line 531 or the second transmission line 532 may correspond to a low-band/mid-band (LB/MB) frequency signal or a high-band (HB) frequency signal. The RF signal transmitted through at least one of the first transmission line 531 or the second transmission line 532 may correspond to a frequency signal (e.g., an N41 band signal) used for 5G communication. The RF signal transmitted through at least one of the first transmission line 531 or the second transmission line 532 may correspond to a reference signal (e.g., an SRS). According to an embodiment, an RF signal received from the outside of the electronic device 101 through the first antenna 541 may be transmitted to at least one of the first transmission line 531 or the second transmission line 532 through the second PCB 520. The RF signal transmitted through at least one of the first transmission line 531 or the second transmission line 532 from the second PCB 520 may be transmitted to the RFIC 410 included in the first PCB 510. For example, the RF signal transmitted through at least one of the first transmission line 531 or the second transmission line 532 from the second PCB 520 may be amplified through an LNA included in the first PAM 511, the second PAM 512, or the third PAM 513 of the first PCB 510 and then transmitted to the RFIC 410.

According to an embodiment, a third transmission line 533 and a fourth transmission line 534 included in the FPCB 530 may be used for transmitting a transmission signal (Tx signal) or transmitting a reception signal (Rx signal). For example, an RF signal generated in the RFIC 410 may be amplified through the fourth PAM 514 and then transmitted to the second PCB 520 through at least one of the third transmission line 533 or the fourth transmission line 534. The RF signal transmitted to the second PCB 520 through at least one of the third transmission line 533 or the fourth transmission line 534 may be transmitted to the outside of the electronic device 101 (e.g., the base station) through the diplexer 521 and the second antenna 542. The RF signal transmitted through at least one of the third transmission line 533 or the fourth transmission line 534 may correspond to a frequency signal (e.g., an N78 band signal) or an ultra-high-band (UHB) signal used for 5G communication. The RF signal transmitted through at least one of the third transmission line 533 or the fourth transmission line 534 may correspond to a reference signal (e.g., an SRS). According to an embodiment, an RF signal received from the outside of the electronic device 101 through the second antenna 542 may be transmitted to at least one of the third transmission line 533 or the fourth transmission line 534 through the diplexer 521 of the second PCB 520. The RF signal transmitted through at least one of the third transmission line 533 or the fourth transmission line 534 from the second PCB 520 may be transmitted to the RFIC 410 through the fourth PAM 514 of the first PCB 510. For example, the RF signal transmitted through at least one of the third transmission line 533 or the fourth transmission line 534 from the second PCB 520 may be amplified through an LNA included in the fourth PAM 514 of the first PCB 510 and then transmitted to the RFIC 410.

According to an embodiment, a fifth transmission line 535, a sixth transmission line 536, a seventh transmission line 537, or an eighth transmission line 538 included in the FPCB 530 may be used for transmitting a reception signal (Rx signal). For example, an RF signal received from the outside of the electronic device 101 through the second antenna 542 may be subjected to low-noise amplification by an LNA included in the RFFE 522 of the second PCB 520 and then transmitted to at least one of the fifth transmission line 535 to the eighth transmission line 538. The RF signal transmitted through at least one of the fifth transmission line 535 to the eighth transmission line 538 from the second PCB 520 may be transmitted to the RFIC 410 of the first PCB 510. The RF signal transmitted through at least one of the fifth transmission line 535 to the eighth transmission line 538 may correspond to a mid-band (MB) frequency signal or a high-band (HB) frequency signal.

According to an embodiment, as illustrated in FIG. 5, when the PCBs 510 and 520 are connected using the FPCB 530 in the electronic device 101, a signal path for a reception signal may become longer. For example, when an RF transmission line (e.g., the fifth transmission line 535 to the eighth transmission line 538) for transmitting a reception signal among a plurality of RF transmission lines included in the FPCB 530 is adjacent to at least one of RF transmission lines (e.g., the first transmission line 531 to the fourth transmission line 534) allocated as transmission paths, desense (e.g., a decrease in received signal sensitivity) may occur. For example, when at least one RF transmission line for transmitting a reception signal is adjacent to at least one of the RF transmission lines allocated as the transmission paths, a signal (e.g., an uplink signal) transmitted through the RF transmission line allocated as the transmission path may interfere with a signal (e.g., a downlink signal) transmitted through the RF transmission line for transmitting the reception signal, thereby reducing the sensitivity of the received signal. For example, the frequency band (e.g., an N78 or N41 frequency band) of the transmitted signal may be higher than the frequency band (e.g., a B1, B3, B7, or B8 frequency band) of the received signal, but is not limited thereto.

According to an embodiment, in EN-DC, the electronic device 101 may transmit and receive a 5G signal (e.g., an N78 frequency band signal) through one of the first transmission lines 531 to the fourth transmission lines 534 and may receive an LTE signal (e.g., a B1, B3, B6, B7, or B8 frequency band signal) through one of the fifth transmission lines 535 to the eighth transmission lines 538. For example, the LTE signal received through one of the fifth transmission lines 535 to the eighth transmission lines 538 may be desensed by the 5G transmission signal (e.g., an SRS signal) transmitted over one of the first transmission lines 531 to the fourth transmission lines 534.

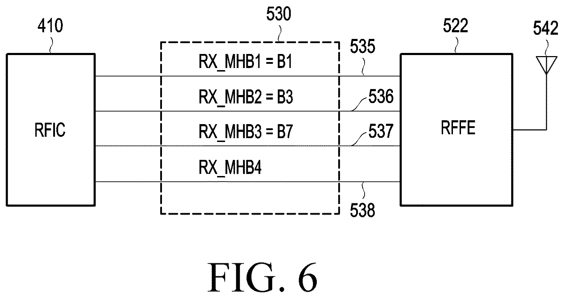

FIG. 6 is a block diagram of an electronic device (e.g., electronic device 101) according to various embodiments.

Referring to FIG. 6, at least some of connection lines between an RFIC (e.g., RFIC 410) and an RFFE (e.g., RFFE 522) may be connected by an FPCB (e.g., FPCB 530). For example, the FPCB 530 may include a fifth transmission line (RX_MHB1) 535, a sixth transmission line (RX_MHB2) 536, a seventh transmission line (RX _MHB3) 537, and an eighth transmission line (RX_MHB4) 538.

According to an embodiment, the RFIC 410 may allocate and use one RF transmission line for each frequency band among the plurality of RF transmission lines included in the FPCB 530 to receive signals in B1, B3, and B7 frequency bands. In carrier aggregation (CA) or EN-DC, the electronic device 101 may sequentially allocate the RF transmission lines whenever each component carrier (CC) is added. For example, a primary component carrier (PCC) may be allocated to the fifth transmission line 535, secondary component carrier 1 (SCC1) may be allocated to the sixth transmission line 536, and SCC2 may be allocated to the seventh transmission line 537. The eighth transmission line 538 may remain unused. A cell corresponding to the PCC may correspond to a primary serving cell (Pcell), and a cell corresponding to the SCCs may correspond to a secondary serving cell (Scell).

According to an embodiment, when a B1 frequency band signal is configured to the PCC, the fifth transmission line 535 may be allocated to receive the B1 frequency band signal. Then, when a B3 frequency band is configured to SCC1, the sixth transmission line 536 may be allocated to receive a B3 frequency band signal. Then, when a B7 frequency band is configured to SCC2, the seventh transmission line 537 may be allocated to receive a B7 frequency band signal. The eighth transmission line 538 may remain unused.

According to an embodiment, as illustrated in FIG. 6, when an RF transmission line (e.g., the fifth transmission line 535, the sixth transmission line 536, or the seventh transmission line 537) for transmitting a reception signal among the plurality of RF transmission lines included in the FPCB 530 is allocated and used as a reception path, desense may occur due to an adjacent RF transmission line among RF transmission lines (e.g., a first transmission line 531 to a fourth transmission line 534) allocated as transmission paths.

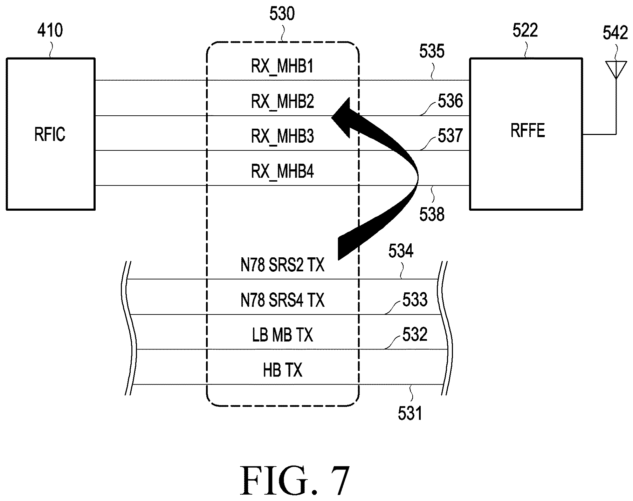

FIG. 7 is a block diagram of an electronic device (e.g., electronic device 101) according to various embodiments.

Referring to FIG. 7, according to an embodiment, as illustrated in FIG. 6, when at least one RF transmission line (e.g., a fifth transmission line 535, a sixth transmission line 536, or a seventh transmission line 537) for transmitting a reception signal among a plurality of RF transmission lines included in a FPCB 530 is adjacent to at least one of RF transmission lines (e.g., a first transmission line 531 to a fourth transmission line 534) allocated as transmission paths, desense may occur. For example, when at least one RF transmission line (e.g., the fifth transmission line 535, the sixth transmission line 536, or the seventh transmission line 537) for transmitting a reception signal is adjacent to at least one RF transmission line (e.g., the first transmission line 531, the second transmission line 532, the third transmission line 533, and the fourth transmission line 534) allocated as a transmission path, a signal (e.g., an uplink signal) transmitted through the RF transmission line allocated as the transmission path may interfere with a signal (e.g., a downlink signal) transmitted through the RF transmission line for transmitting the reception signal, thereby reducing the sensitivity of the received signal.

According to an embodiment, the RF transmission line for transmitting the reception signal may be disposed adjacent to the RF transmission line allocated as the transmission path. For example, reception/transmission RF transmission lines may be disposed on the same FPCB. However, reception/transmission RF transmission lines are not limited to this example, and may be disposed on two or more adjacent FPCBs, respectively.

Desense may have different effects (e.g., sensitivity) depending on the physical proximity of RF transmission lines. For example, when the fourth transmission line 534 and the sixth transmission line 536 are closest to each other in a line layout, the reception quality of a reception signal (e.g., a downlink signal) through the sixth transmission line may be most significantly affected by a transmission signal (e.g., an uplink signal) transmitted through the fourth transmission line.

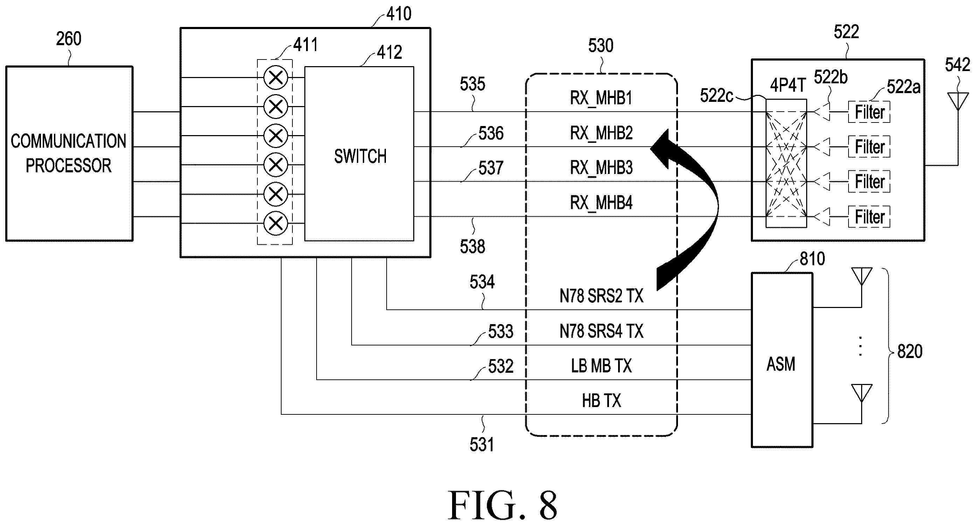

FIG. 8 is a block diagram of an electronic device (e.g., electronic device 101) according to various embodiments.

Referring to FIG. 8, at least some of connection lines between an RFIC (e.g., RFIC 410) and an RFFE (e.g., RFFE 522) may be connected by an FPCB (e.g., FPCB 530). The RFIC 410 may include a plurality of mixers 411 and a first switch 412. Each of the plurality of mixers 411 may be designed to process a signal in a specific frequency band but is not limited thereto. The RFFE 522 may include a plurality of filters 522a, a plurality of LNAs 522b, and a second switch 522c (e.g., a 4P4T switch). The FPCB 530 may include a plurality of RF transmission lines. For example, as described above, the FPCB 530 may include a plurality of RF transmission lines (e.g., a fifth transmission line 535 to an eighth transmission line 538) for transmitting a reception signal received through an antenna 542 from the RFFE 522 to the RFIC 410. The FPCB 530 may include a plurality of RF transmission lines (e.g., a first transmission line 531 to a fourth transmission line 534) for transmitting a transmission signal through at least one antenna 820 from the RFIC 410. An antenna switching module (ASM) 810 may be coupled between the RFIC 410 and the at least one antenna 820. According to an embodiment, as illustrated in FIG. 5, at least one power amplifier module (PAM) 511, 512, 513, and 514 including at least one power amplifier (PA) may be included as at least one RFFE between the RFIC 410 and the plurality of RF transmission lines (e.g., the first transmission line 531 to the fourth transmission line 534) for transmitting the transmission signal.

According to an embodiment, as described above, at least one RF transmission line among the plurality of RF transmission lines (e.g., the first transmission line 531 to the fourth transmission line 534) allocated to transmit the transmission signal (Tx signal) may affect at least one RF transmission line among the plurality of RF transmission lines (e.g., the fifth transmission line 535 to the eighth transmission line 538) allocated to transmit the reception signal (Rx signal).

According to an embodiment, when desense occurs in at least one RF transmission line among the fifth transmission line 535 to the eighth transmission line 538, the electronic device 101 may change a reception path such that a reception signal received through the RF transmission line where the desense occurs is received through another RF transmission line. According to an embodiment, the electronic device 101 (e.g., a communication processor 260) may control the switch 522c included in the RFFE 522, thereby changing an RF transmission line for each reception signal.

According to an embodiment, when desense occurs in at least one RF transmission line among the fifth transmission line 535 to the eighth transmission line 538, the electronic device 101 may control the switch 522c included in the RFFE 522 to change the RF transmission line for at least one (e.g., for each) reception signal, thus changing a signal received from the mixers 411 through the switch 412 of the RFIC 410. Accordingly, the electronic device 101 may control the first switch 412 so that the reception signal input to the mixers 411 through the first switch 412 is suitable for a frequency band processable by each mixer.

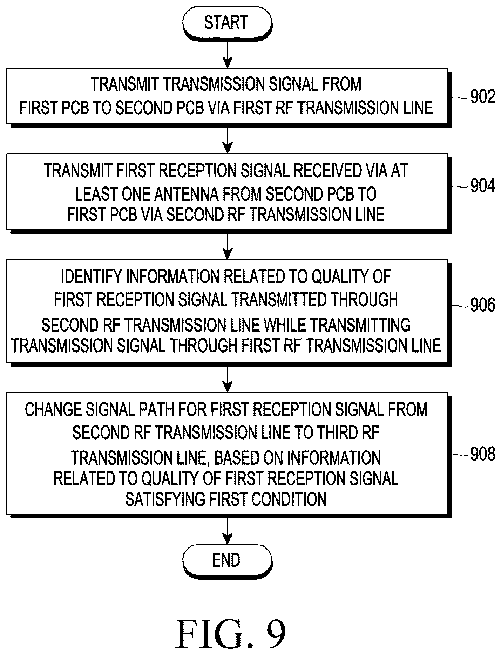

FIG. 9 is a flowchart illustrating an operating method of an electronic device (e.g., electronic device 101) according to various embodiments.

In the following embodiments, operations may be sequentially performed but are not necessarily sequentially performed. For example, the order of the operations may be changed, and at least two operations may be performed in parallel.

According to an embodiment, the electronic device (e.g., electronic device 101) may include a first PCB (e.g., PCB 510) including an RFIC (e.g., RFIC 410) (e.g., an RF transceiver circuit). The electronic device may include a second PCB (e.g., PCB 520) including an RFFE (e.g., RFFE 522) (e.g., an RFFE circuit 522) connected to at least one antenna (e.g., the second antenna 542 as illustrated in FIG. 5, for example). The electronic device may include an FPCB (e.g., FPCB 530) connected to the first PCB 510 and the second PCB 520 therebetween. The FPCB 530 may include a plurality of transmission lines (e.g., a first transmission line 531 to an eighth transmission line 538) including a first RF transmission line, a second RF transmission line, and a third RF transmission line. The electronic device may include memory (e.g., the memory 130 as illustrated exemplarily in FIG. 1) storing instructions. The electronic device may include at least one processor (e.g., at least one of a processor 120, a first communication processor 212, a second communication processor 214, and/or an integrated communication processor 260). When executed by the at least one processor individually or collectively, the instructions may cause the electronic device to perform at least one operation. However, the electronic device 101 may have other suitable components to realize operations described herein.

According to various embodiments, in operation 902, the electronic device (e.g., electronic device 101) (e.g., at least one of the processor 120, the first communication processor 212, the second communication processor 214, and/or the integrated communication processor 260) may transmit a transmission signal from the first PCB to the second PCB via the first RF transmission line (e.g., at least one RF transmission line among the first transmission line 531 to the fourth transmission line 534 as illustrated exemplarily in FIG. 5).

According to various embodiments, in operation 904, the electronic device (e.g., electronic device 101) may control transmission of a first reception signal (Rx signal) received via the at least one antenna from the second PCB to the first PCB via the second RF transmission line (e.g., at least one RF transmission line among the fifth transmission line 535 to the eighth transmission line 538 as illustrated exemplarily in FIG. 5).

According to various embodiments, in operation 906, the electronic device (e.g., electronic device 101) may identify information related to the quality of the first reception signal transmitted through the second RF transmission line while transmitting the transmission signal through the first RF transmission line. For example, the information related to the quality of the first reception signal may include at least one of a reference signal received power (RSRP), a received signal strength indicator (RSSI), a reference signal received quality (RSRQ), a signal-to-interference plus noise ratio (SINR), and/or a signal-to-noise ratio (SNR).

According to various embodiments, in operation 908, the electronic device (e.g., electronic device 101) may control change of a signal path for the first reception signal from the second RF transmission line to the third RF transmission line, based on the information related to the quality of the first reception signal satisfying a first condition. For example, in operation 908, the electronic device 101 may control the change of the signal path for the first reception signal from the sixth transmission line 536 to the eighth transmission line 538, based on the information related to the quality of the first reception signal satisfying the first condition. According to various embodiments, the electronic device (e.g., electronic device 101) may control maintenance of the transmission of the first reception signal through the second RF transmission line, based on the information related to the quality of the first reception signal satisfying a second condition. According to an embodiment, the second condition may correspond to a pass condition, and the first condition may correspond to a fail condition. For example, when the RSRP of the first reception signal is equal to or greater than a first threshold value (e.g., -80 dBm), the electronic device 101 may determine that the second condition is satisfied. When the RSRP of the first reception signal is less than a second threshold value (e.g., -100 dBm), the electronic device 101 may determine that the first condition is satisfied. The first threshold value and the second threshold value may be configured to be the same or different from each other. When the SINR of the first reception signal is equal to or greater than a third threshold value (e.g., 21 dB), the electronic device 101 may determine that the second condition is satisfied. When the SINR of the first reception signal is less than a fourth threshold value (e.g., 20 dB), the electronic device 101 may determine that the second condition is satisfied. The third threshold value and the fourth threshold value may be configured to be the same or different from each other. In various embodiments to be described below, the SINR is illustrated as an example of the information related to the quality of the reception signal. In the embodiments to be described below, the SINR may be replaced with at least one of the foregoing RSRP, RSSI, RSRQ, or SNR.

According to various embodiments, as described above, the electronic device (e.g., electronic device 101) may be of a form factor including a plurality of housings. For example, the electronic device 101 may include a foldable electronic device, a slidable electronic device, or a rollable electronic device including a plurality of housings. According to an embodiment, when the form of the electronic device 101 is changed from a first state (e.g., an open state) to a second state (e.g., a closed state), the transmission line for the transmission signal may be changed from the first RF transmission line to another transmission line. In addition, as the transmission line for the transmission signal is changed, a transmission line for at least one reception signal may be changed to another transmission line. When the transmission line for the transmission signal or the transmission line for the reception signal is changed, the electronic device 101 may perform operation 906 and operation 908 described above.

According to various embodiments, in operation 908, the electronic device (e.g., electronic device 101) may control the change of the signal path for the first reception signal and also change of a path for the transmission signal, based on the information related to the quality of the first reception signal satisfying the first condition. For example, the electronic device 101 may control switch of the transmission line for the transmission signal with a path that is further apart from the transmission line for the reception signal. For example, when the first condition is still satisfied despite changing the signal path for the first reception signal, the electronic device 101 may control switch of the transmission line for the transmission signal with a path that is still further apart from the transmission line for the reception signal. For example, the electronic device 101 may control switch of the transmission line for the transmission signal with a path that is not in use or with another transmission path or reception path that is currently in use. For example, when the first condition is still satisfied despite changing the signal path for the first reception signal, the electronic device 101 may control switch of the transmission line for the transmission signal with a path that is further apart from the transmission line for the reception signal and is not in use or with another transmission path or reception path that is currently in use.

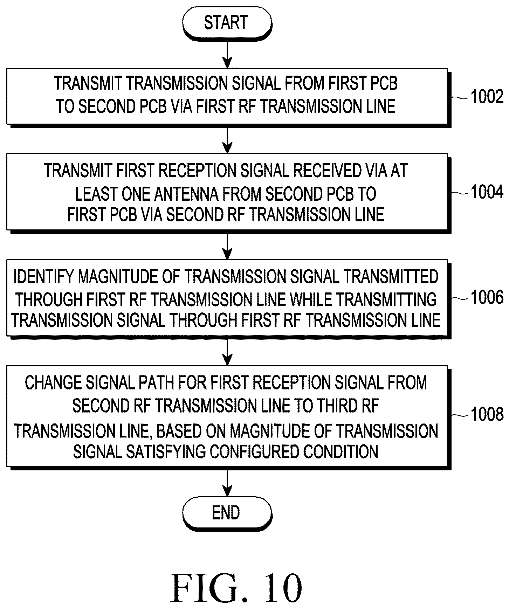

FIG. 10 is a flowchart illustrating an operating method of an electronic device (e.g., electronic device 101) according to various embodiments.

In the following embodiments, operations may be sequentially performed but are not necessarily sequentially performed. For example, the order of the operations may be changed, and at least two operations may be performed in parallel.

According to an embodiment, the electronic device (e.g., electronic device 101) may include a first PCB 510 including an RFIC 410 (or an RF transceiver circuit). The electronic device may include a second PCB 520 including an RFFE 522 (or an RFFE circuit) connected to at least one antenna (e.g., the second antenna 542 as illustrated exemplarily in FIG. 5). The electronic device may include an FPCB 530 connected to the first PCB 510 and the second PCB 520 therebetween. The FPCB 530 may include a plurality of transmission lines (e.g., a first transmission line 531 to an eighth transmission line 538) including a first RF transmission line, a second RF transmission line, and a third RF transmission line. The electronic device may include memory (e.g., the memory 130 as illustrated exemplarily in FIG. 1) storing instructions. The electronic device may include at least one processor (e.g., at least one of a processor 120, a first communication processor 212, a second communication processor 214, or an integrated communication processor 260). When executed by the at least one processor individually or collectively, the instructions may cause the electronic device to perform at least one operation. However, the electronic device 101 may have other suitable components to realize functions and/or operations described herein.

According to various embodiments, in operation 1002, the electronic device (e.g., electronic device 101) (e.g., at least one of the processor 120, the first communication processor 212, the second communication processor 214, or the integrated communication processor 260) may transmit a transmission signal from the first PCB to the second PCB via the first RF transmission line (e.g., at least one RF transmission line among the first transmission line 531 to the fourth transmission line 534 as illustrated exemplarily in FIG. 5).

According to various embodiments, in operation 1004, the electronic device (e.g., electronic device 101) may control a first reception signal (Rx signal) received via the at least one antenna to be transmitted from the second PCB to the first PCB via the second RF transmission line (e.g., at least one RF transmission line among the fifth transmission line 535 to the eighth transmission line 538 as illustrated exemplarily in FIG. 5).

According to various embodiments, in operation 1006, the electronic device (e.g., electronic device 101) may identify the strength and/or magnitude of the transmission signal transmitted through the first RF transmission line while transmitting the transmission signal through the first RF transmission line.

According to various embodiments, in operation 1008, the electronic device (e.g., electronic device 101) may control change of a signal path for the first reception signal from the second RF transmission line to the third RF transmission line, based on the strength and/or magnitude of the transmission signal satisfying a configured condition. For example, in operation 1008, the electronic device 101 may control the change of the signal path for the first reception signal from the sixth transmission line 536 to the eighth transmission line 538, based on the strength or magnitude of the transmission signal satisfying the configured condition. According to an embodiment, the condition for changing the transmission line may include not only the strength and/or magnitude of the transmission signal but also transmission time. According to an embodiment, the configured condition may be stored separately by frequency band. The configured condition may be configured by a manufacturer, configured by a user, or configured or updated through artificial intelligence learning. In various embodiments to be described below, the information related to the quality of the reception signal configured as the condition for changing the signal path for the reception signal in FIG. 9 may be replaced with the strength or magnitude of the transmission signal illustrated in FIG. 10.

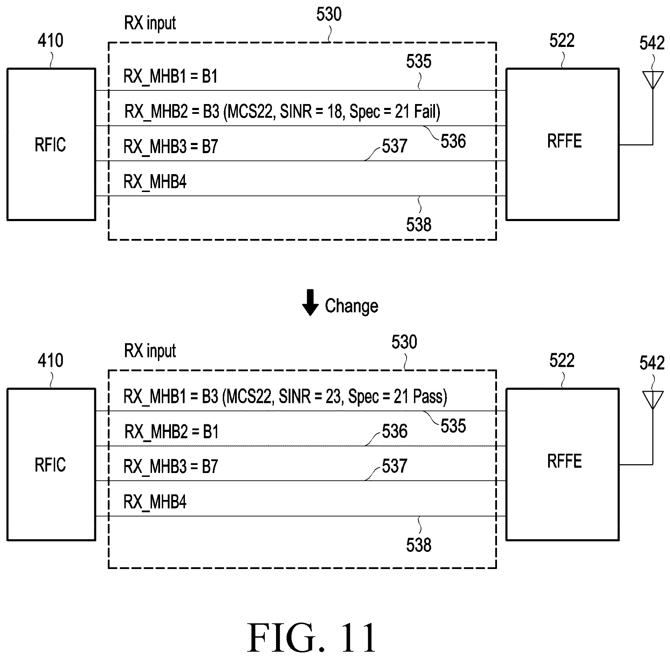

FIG. 11 is a block diagram of an electronic device (e.g., electronic device 101) according to various embodiments.

Referring to FIG. 11, according to various embodiments, the electronic device 101 may include an FPCB 530 electrically connected to an RFIC 410 and an RFFE 522 therebetween. The FPCB 530 may include RF transmission lines (e.g., a fifth transmission line 535 to an eighth transmission line 538) corresponding to four reception paths.

According to an embodiment, when an SINR measured in the frequency band of each reception signal forming a CA and EN-DC combination satisfies a first condition (e.g., is less than or equal to a first threshold value), the electronic device 101 may change a reception path for each reception signal by controlling a switch (e.g., the switch 522c as illustrated exemplarily in FIG. 8) included in the RFFE 522 as illustrated in FIG. 8. For example, the electronic device 101 may change the reception path for each reception signal until reception signals in all frequency bands forming the CA and EN-DC combination satisfy an SINR reference value. The SINR reference value may be configured to be the same or differently for each frequency band.

Referring to FIG. 11, according to an embodiment, the electronic device 101 may transmit a transmission signal from a first PCB (e.g., the RFIC 410) to a second PCB (e.g., the RFFE 522) through a first RF transmission line (e.g., at least one RF transmission line among the first transmission line 531 to the fourth transmission line 534 as illustrated exemplarily in FIG. 5). The electronic device 101 may control transmission of a plurality of reception signals (Rx signals) received through at least one antenna (e.g., a second antenna 542) from the second PCB (e.g., from the RFFE 522 of the second PCB) to the first PCB (e.g., to the RFIC 410 of the first PCB) through at least one RF transmission line among a plurality of RF transmission lines (e.g., the fifth transmission line 535 to the eighth transmission line 538 as illustrated exemplarily in FIG. 5) while transmitting the transmission signal. For example, as illustrated in FIG. 11, a reception signal in a B1 frequency band received through the at least one antenna (e.g., the second antenna 542) may be transmitted from the RFFE 522 to the RFIC 410 through the fifth transmission line 535 of the FPCB 530. A reception signal in a B3 frequency band received through the at least one antenna (e.g., the second antenna 542) may be transmitted from the RFFE 522 to the RFIC 410 through the sixth transmission line 536 of the FPCB 530. A reception signal in a B7 frequency band received through the at least one antenna (e.g., the second antenna 542) may be transmitted from the RFFE 522 to the RFIC 410 through the seventh transmission line 537 of an FPCB 530.

According to various embodiments, the electronic device 101 may identify information related to the quality of each reception signal while transmitting the transmission signal. For example, the information related to the quality of the reception signal may include at least one of a reference signal received power (RSRP), a received signal strength indicator (RSSI), a reference signal received quality (RSRQ), a signal-to-interference plus noise ratio (SINR), and/or a signal-to-noise ratio (SNR).

According to various embodiments, the electronic device 101 may determine whether the information (e.g., SINR) related to the quality of the reception signal satisfies the first condition. According to an embodiment, the electronic device 101 may store an SINR reference value for each modulation and coding scheme (MCS) for frequency bands forming CA and EN-DC in the form of a table in memory (e.g., the memory 130 as illustrated exemplarily in FIG. 1) as shown below in Table 1.

**[Table 1]**

| MCS | Reference SINR (dB) |
|---|---|
| 27 | 33 |
| 26 | 31 |
| 25 | 29 |
| 24 | 27 |
| 23 | 21 |
| 22 | 21 |
| 21 | 21 |
| 20 | 19 |
| 19 | 19 |
| 18 | 19 |
| 17 | 19 |
| 16 | 17 |
| 15 | 17 |
| 14 | 17 |
| 13 | 17 |
| 12 | 17 |
| 11 | 15 |
| 10 | 15 |
| 9 | 15 |
| 8 | 15 |
| 7 | 15 |
| 6 | 15 |
| 5 | 15 |

In Table 1, the SINR reference value for each MCS may be configured in view of block error rate (BLER) or data throughput according to the model of each electronic device 101. As described above, in various embodiments, the SINR may be replaced with other values (e.g., the RSRP, RSSI, RSRQ, or SNR) indicating the strength and/or quality of the signal.

According to an embodiment, as illustrated in FIG. 11, the B3 frequency band transmitted through the sixth transmission line 536 may have an MCS configured to 22, and the SINR of the reception signal may be identified as 18 dB. Referring to Table 1, when the MCS is 22, the SINR reference value may be configured to 21 dB. As the SINR of the reception signal corresponding to the B3 frequency band is identified as 18 dB, the electronic device 101 may identify that the SINR of the reception signal is less than the SINR reference value. As identifying that the identified SINR is less than the configured reference value, the electronic device 101 may identify that the first condition (e.g., fail condition) is satisfied. The electronic device 101 may change a signal path for the reception signal corresponding to the B3 frequency band to another signal path, based on identifying that the first condition is satisfied. For example, the electronic device 101 may change the signal path for the reception signal corresponding to the B3 frequency band from the sixth transmission line 536 to the fifth transmission line 535. A signal path for the reception signal corresponding to the B1 frequency band transmitted through the fifth transmission line 535 may be changed from the fifth transmission line 535 to the sixth transmission line 536. As a result of changing the signal path for the reception signal corresponding to the B3 frequency band, the SINR may be identified as 23 dB. As the SINR of the reception signal corresponding to the B3 frequency band is identified as 23 dB, the electronic device 101 may identify that the SINR of the reception signal corresponding to the B3 frequency band is higher than the SINR reference value. As identifying that the identified SINR is higher than the configured reference value, the electronic device 101 may identify that a second condition (e.g., a pass condition) is satisfied. The electronic device 101 may maintain the signal path for the reception signal corresponding to the B3 frequency band as the currently changed signal path (e.g., the fifth transmission line 535), based on identifying that the second condition is satisfied.

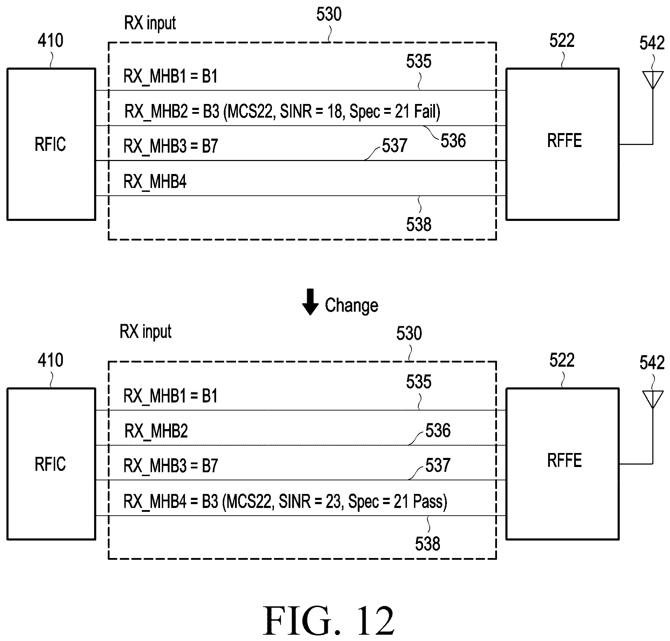

FIG. 12 is a block diagram of an electronic device (e.g., electronic device 101) according to various embodiments.

Referring to FIG. 12, according to an embodiment, the electronic device 101 may transmit a transmission signal from a first PCB (e.g., an RFIC 410) to a second PCB (e.g., an RFFE 522) through a first RF transmission line (e.g., at least one RF transmission line among the first transmission line 531 to the fourth transmission line 534 as illustrated exemplarily in FIG. 5). The electronic device 101 may control transmission of a plurality of reception signals (Rx signals) received through at least one antenna (e.g., a second antenna 542) from the second PCB (e.g., the RFFE 522) to the first PCB (e.g., the RFIC 410) through at least one RF transmission line among a plurality of RF transmission lines (e.g., the fifth transmission line 535 to the eighth transmission line 538 as illustrated exemplarily in FIG. 5) while transmitting the transmission signal. For example, as illustrated in FIG. 12, a reception signal in a B1 frequency band received through the at least one antenna (e.g., the second antenna 542) may be transmitted from the RFFE 522 to the RFIC 410 through the fifth transmission line 535 of the FPCB 530. A reception signal in a B3 frequency band received through the at least one antenna (e.g., the second antenna 542) may be transmitted from the RFFE 522 to the RFIC 410 through the sixth transmission line 536 of the FPCB 530. A reception signal in a B7 frequency band received through the at least one antenna (e.g., the second antenna 542) may be transmitted from the RFFE 522 to the RFIC 410 through the seventh transmission line 537 of an FPCB 530. Prior to a change of a transmission line, as illustrated exemplarily in FIG. 12, the eighth transmission line 538 may be not in use for reception of reception signal.

According to various embodiments, the electronic device 101 may identify information (e.g., SINR) related to the quality (e.g., the quality under consideration of the signal strength) of each reception signal while transmitting the transmission signal. According to various embodiments, the electronic device 101 may determine whether the information related to the quality of the reception signal satisfies a first condition. According to an embodiment, as illustrated in FIG. 12, the B3 frequency band transmitted through the sixth transmission line 536 may have an MCS configured to 22, and the SINR of the reception signal may be identified as 18 dB. Referring to Table 1, when the MCS is 22, an SINR reference value may be configured to 21 dB. As the SINR of the reception signal corresponding to the B3 frequency band is identified as 18 dB, the electronic device 101 may identify that the SINR of the reception signal is less than the SINR reference value. As identifying that the identified SINR is less than the configured reference value, the electronic device 101 may identify that the first condition (e.g., fail condition) is satisfied. The electronic device 101 may change a signal path for the reception signal corresponding to the B3 frequency band to another signal path currently not in use, based on identifying that the first condition is satisfied. For example, the electronic device 101 may change the signal path for the reception signal corresponding to the B3 frequency band from the sixth transmission line 536 to the eighth transmission line 538. As a result of changing the signal path for the reception signal corresponding to the B3 frequency band, the SINR may be identified as 23 dB. As the SINR of the reception signal corresponding to the B3 frequency band is identified as 23 dB, the electronic device 101 may identify that the SINR of the reception signal corresponding to the B3 frequency band is higher than the SINR reference value. As identifying that the identified SINR is higher than the configured reference value, the electronic device 101 may identify that a second condition (e.g., a pass condition) is satisfied. The electronic device 101 may maintain the signal path for the reception signal corresponding to the B3 frequency band as the currently changed signal path (e.g., the eighth transmission line 538), based on identifying that the second condition is satisfied.

Referring to FIG. 11 and FIG. 12, the electronic device 101 may swap or exchange a signal path for a reception signal satisfying the first condition (e.g., the fail condition) among reception signals corresponding CCs forming CA and EN-DC with a signal path for another reception signal, thereby identifying a combination of signal paths in which reception signals in all frequency bands satisfy a reference SINR. According to an embodiment, when there is an unused signal path in CA, the electronic device 101 may maintain a signal path for a reception signal in a frequency band not satisfying the first condition, and may change a signal path for a reception signal in a frequency band satisfying the first condition to the unused signal path as illustrated in FIG. 12 (e.g., as illustrated for a case in which a change of the signal path includes a change from sixth transmission line 536 to an unused eighth transmission line 538 only as an example).

Referring to FIG. 11, the reception signal in the B1 frequency band, for which the signal path is exchanged with the signal path for the B3 frequency band, may correspond to a signal having the highest SINR among signals currently being received. According to an embodiment, as illustrated in FIG. 11, after the signal path for the reception signal corresponding to the B1 frequency band is switched to the sixth transmission line 536, the electronic device 101 may determine whether the SINR of the reception signal corresponding to the B1 frequency band satisfies the first condition. When the SINR of the reception signal corresponding to the B1 frequency band does not satisfy the first condition (e.g., is equal to or greater than a first threshold value), the electronic device 101 may control maintenance of the switched signal path (e.g., the sixth transmission line 536). After the signal path for the reception signal corresponding to the B1 frequency band is switched to the sixth transmission line 536, when the SINR of the reception signal satisfies the first condition (e.g., is less than the first threshold value), the electronic device 101 may change the signal path for the reception signal corresponding to the B1 frequency band to another signal path. According to an embodiment, when the reception signal corresponding to the B3 frequency band still satisfies the first condition after the signal path is changed, the signal path for the reception signal corresponding to the B3 frequency band may be exchanged with a reception signal of another signal path (e.g., the seventh transmission line 537 or the eighth transmission line 538) thereby enabling the SINRs of all reception signals to satisfy the reference value. According to an embodiment, when there is an unused signal path (e.g., the eighth transmission line 538) in CA as illustrated exemplarily in FIG. 12, a signal path for a reception signal in a frequency band satisfying the first condition may be preferentially changed to the unused signal path with other signal paths being left as they are. According to an embodiment, when there is no combination in which the reference SINR is not satisfied for all the reception signals, a combination in which the difference between the SINR and the reference value is the smallest from all the reception paths may be selected. According to an embodiment, when there is no combination in which the reference SINR is not satisfied for all the reception signals, a combination based on the priority of the reception signal may be selected.

According to an embodiment, when a signal path for a reception signal corresponding to a CC satisfying the first condition among the CCs forming the CA and EN-DC is identified, the electronic device 101 may identify a value satisfying the SINR while changing a combination of frequency bands for the CA in a predetermined order. Information about a combination of signal paths according to the predetermined order may be generated in the form of a table in memory (e.g., the memory 130 as illustrated exemplarily in FIG. 1), and each signal path may be stored as a code. For example, when the B1 frequency band, the B3 frequency band, and the B7 frequency band form the CA, PCC = B1, SCC1 = B3, and SCC2 = B7 of LTE may be configured. According to an embodiment, the B1 frequency band may be configured to the fifth transmission line 535, the B3 frequency band may be configured to the sixth transmission line 536, and the B7 frequency band may be configured to the seventh transmission line 537. According to an embodiment, when the SINR of the reception signal corresponding to the B3 frequency band is identified as a value less than or equal to the reference value, it may be identified whether the SINRs of all the reception signals satisfy the second condition while sequentially changing a combination of signal paths according to a preset order.

According to an embodiment, when a signal path for a reception signal has four signal paths (e.g., the fifth transmission line 535, the sixth transmission line 536, the seventh transmission line 537, and the eighth transmission line 538) as in the foregoing examples, 1CA may have 4 cases, 2CA may have 12 cases, 3CA may have 24 cases, and 4CA may have 24 cases as shown in Table 2, Table 3, and Table 4. In Table 2, Table 3, and Table 4, MHB1 may correspond to the fifth transmission line 535, MHB2 may correspond to the sixth transmission line 536, MHB3 may correspond to the seventh transmission line 537, and MHB4 may correspond to the eighth transmission line 538.

**[Table 2]**

| Rx Path Code | CC#1 |
|---|---|
| 1 | MHB1 |
| 2 | MHB2 |
| 3 | MHB3 |
| 4 | MHB4 |

**[Table 3]**

| Rx Path Code | CC#1 | CC#2 |
|---|---|---|
| 1 | MHB1 | MHB2 |
| 2 | MHB1 | MHB3 |
| 3 | MHB1 | MHB4 |
| 4 | MHB2 | MHB1 |
| 5 | MHB2 | MHB3 |
| 6 | MHB2 | MHB4 |
| 7 | MHB3 | MHB1 |
| 8 | MHB3 | MHB2 |
| 9 | MHB3 | MHB4 |
| 10 | MHB4 | MHB1 |
| 11 | MHB4 | MHB2 |
| 12 | MHB4 | MHB3 |

**[Table 4]**

| Rx Path Code | CC#1 | CC#2 | CC#3 |
|---|---|---|---|
| 1 | MHB1 | MHB2 | MHB3 |
| 2 | MHB1 | MHB2 | MHB4 |
| 3 | MHB1 | MHB3 | MHB2 |
| 4 | MHB1 | MHB3 | MHB4 |
| 5 | MHB1 | MHB4 | MHB2 |
| 6 | MHB1 | MHB4 | MHB3 |
| 7 | MHB2 | MHB1 | MHB3 |
| 8 | MHB2 | MHB1 | MHB4 |
| 9 | MHB2 | MHB3 | MHB1 |
| 10 | MHB2 | MHB3 | MHB4 |
| 11 | MHB2 | MHB4 | MHB1 |
| 12 | MHB2 | MHB4 | MHB3 |
| 13 | MHB3 | MHB1 | MHB2 |
| 14 | MHB3 | MHB1 | MHB4 |
| 15 | MHB3 | MHB2 | MHB1 |
| 16 | MHB3 | MHB2 | MHB4 |
| 17 | MHB3 | MHB4 | MHB1 |
| 18 | MHB3 | MHB4 | MHB2 |
| 19 | MHB4 | MHB1 | MHB2 |
| 20 | MHB4 | MHB1 | MHB3 |
| 21 | MHB4 | MHB2 | MHB1 |
| 22 | MHB4 | MHB2 | MHB3 |
| 23 | MHB4 | MHB3 | MHB1 |
| 24 | MHB4 | MHB3 | MHB2 |

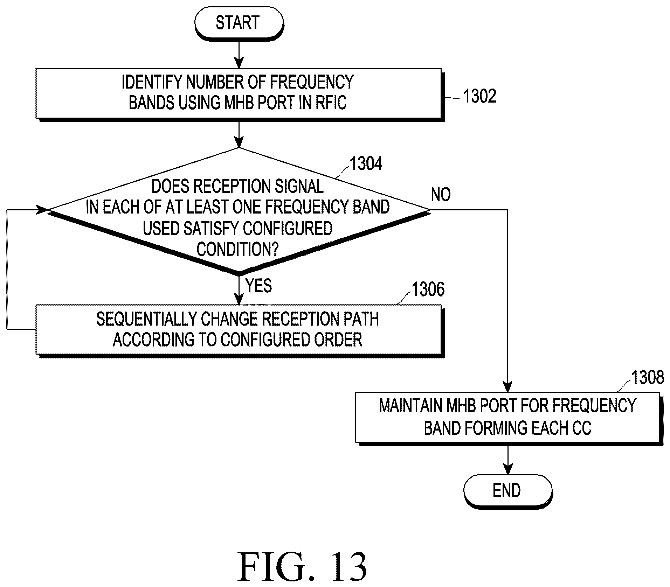

FIG. 13 is a flowchart illustrating an operating method of an electronic device (e.g., electronic device 101) according to various embodiments.

Referring to FIG. 13, according to various embodiments, the electronic device 101 may include an FPCB 530 electrically connected to an RFIC 410 and an RFFE 522 therebetween. The FPCB 530 may include RF transmission lines (e.g., a fifth transmission line 535 to an eighth transmission line 538) corresponding to four reception paths. However, the electronic device 101 may have other suitable components to realize functions and/or operations described herein.

According to an embodiment, in operation 1302, the electronic device 101 may identify the number of frequency bands using a reception path (e.g., an MHB port) corresponding to MHB in the RFIC 410. For example, the number (N) of frequency bands using the reception path corresponding to the MHB may be 1 to 4 but is not limited thereto.

According to an embodiment, in operation 1304, the electronic device 101 may identify whether a reception signal in each of at least one frequency band used satisfies a configured condition (e.g., a first condition). For example, in operation 1304, the electronic device 101 may identify whether the SINR of the reception signal in each frequency band used is less than a reference SINR per MCS (e.g., as exemplarily shown in Table 1).

According to an embodiment, when the reception signal in each frequency band does not satisfy the configured condition (e.g., the first condition) (No in operation 1304), reception signals in each of all frequency bands are in a good state, and thus the electronic device 101 may control maintenance of a current signal path (e.g., the MHB port) for the frequency band forming each CC in operation 1308.

According to an embodiment, when the reception signal in each frequency band satisfies the configured condition (e.g., the first condition) (Yes in operation 1304), the electronic device 101 may sequentially change the signal path for the reception signal in each frequency band according to a combination in Table 2, Table 3, or Table 4 described above according to the number of N until the configured condition is not satisfied in operation 1306.

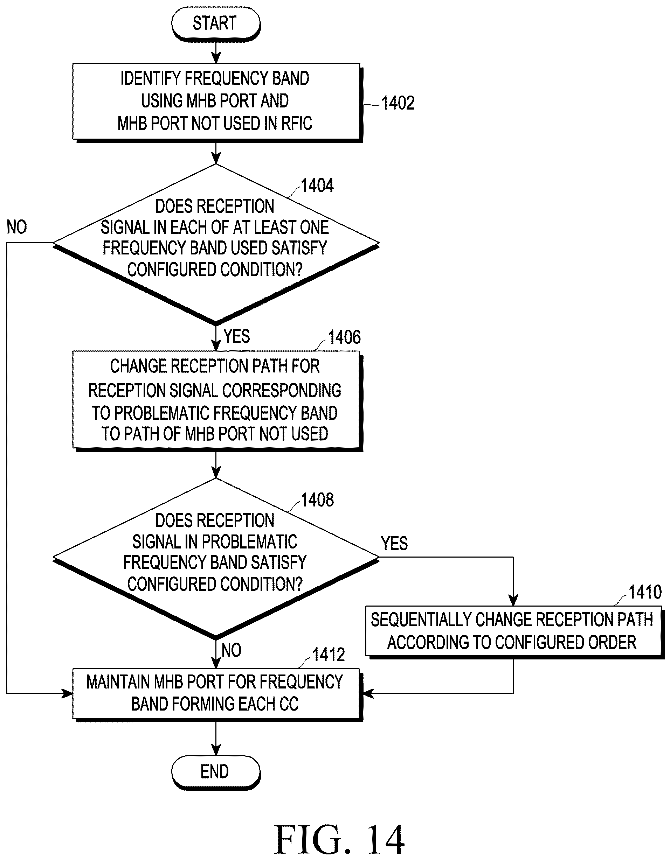

FIG. 14 is a flowchart illustrating an operating method of an electronic device (e.g., electronic device 101) according to various embodiments.

Referring to FIG. 14, according to various embodiments, the electronic device 101 may include an FPCB 530 electrically connected to an RFIC 410 and an RFFE 522 therebetween. The FPCB 530 may include RF transmission lines (e.g., a fifth transmission line 535 to an eighth transmission line 538) corresponding to four reception paths. However, the electronic device 101 may have other suitable components to realize functions and/or operations described herein.

According to an embodiment, in operation 1402, the electronic device 101 may identify a frequency band using a reception path (e.g., an MHB port) corresponding to MHB in the RFIC 410 and a frequency band not using the same.

According to an embodiment, in operation 1404, the electronic device 101 may identify whether a reception signal in each of at least one frequency band currently used satisfies a configured condition (e.g., a first condition). For example, in operation 1404, the electronic device 101 may identify whether the SINR of the reception signal in each frequency band used is less than a reference SINR per MCS (e.g., as exemplarily shown in Table 1).

According to an embodiment, when the reception signal in each of the at least one frequency band does not satisfy the configured condition (e.g., the first condition) (No in operation 1404), reception signals in each of all frequency bands are in a good state, and thus the electronic device 101 may control maintenance of a current signal path (e.g., the MHB port) for the frequency band forming each CC in operation 1412.

According to an embodiment, when at least one reception signal of the reception signal in each frequency band satisfies the configured condition (e.g., the first condition) (Yes in operation 1404), the electronic device 101 may change a reception path for a reception signal corresponding to a problematic frequency band to the path of the MHB port that is not used in operation 1406.

According to an embodiment, after changing the reception path for the reception signal corresponding to the problematic frequency band, the electronic device 101 may identify whether the reception signal in the problematic frequency band satisfies the configured condition in operation 1408.

According to an embodiment, when the reception signal of the problematic frequency band still satisfies the configured condition (e.g., the first condition) despite changing the path (Yes in operation 1408), the electronic device 101 may sequentially change the reception path according to a configured order in operation 1410. For example, the electronic device 101 may identify a reception path in which the reception signal of the problematic frequency band does not satisfy the configured condition while sequentially changing the reception path according to the configured order in operation 1410.

According to an embodiment, when the reception signal of the problematic frequency band does not satisfy the configured condition (e.g., the first condition) after changing the path (No in operation 1408), the electronic device 101 may control maintenance the current signal path (e.g., the MHB port) for the frequency band forming each CC in operation 1412.

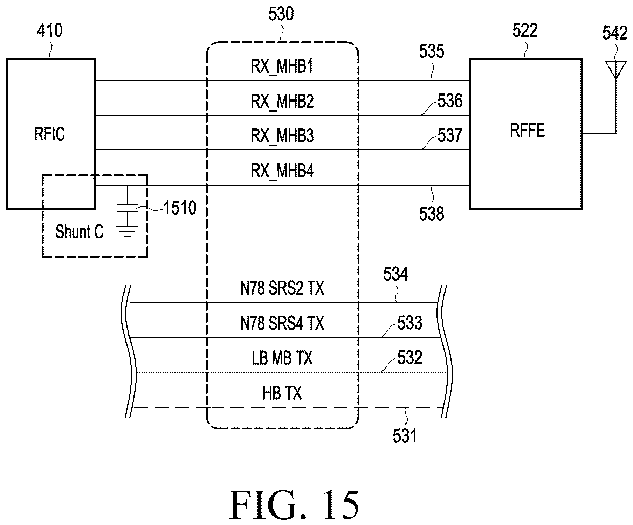

FIG. 15 is a block diagram of an electronic device (e.g., electronic device 101) according to various embodiments.

Referring to FIG. 15, the electronic device (e.g., electronic device 101) may include a shunt capacitor 1510 in at least one RF transmission line (e.g., an eighth transmission line 538) among a plurality of RF transmission lines. For example, as illustrated in the RFIC 410, the shunt capacitor 1510 may be connected in parallel with the eighth transmission line 538 in an RF input portion into which the eighth transmission line 538 is input. For example, one end of the shunt capacitor 1510 may be connected to a point of the eighth transmission line 538, and the other end may be connected to a ground. The value of the shunt capacitor 1510 may be configured to a value (e.g., 2.2 pF, 2.7 pF, or 3.3 pF) that minimizes desense depending on a combination of reception signals in each frequency band. According to an embodiment, when a reception signal transmitted through a specific RF transmission line among four RF transmission lines (e.g., a fifth RF transmission line 535 to the eighth RF transmission line 538) satisfies a first condition, a signal path for the reception signal may be changed to the RF transmission line (e.g., the eighth transmission line 538) to which the shunt capacitor 1510 is added.

According to an embodiment, when the shunt capacitor 1510 is added between the RFIC 410 and an RFFE 522, desense due to a transmission signal (e.g., an N78 transmission signal) may be reduced. According to an embodiment, the shunt capacitor 1510 may be disposed adjacent to the RFIC 410 (e.g., between the FPCB 530 and the RFIC 410) to enhance, for example, a desense reduction effect. According to an embodiment, when the power of the transmission signal is equal to or greater than a configured value and at least one reception signal satisfies the first condition, a signal path for the reception signal satisfying the first condition may be changed to a signal path in which the shunt capacitor 1510 is disposed. According to an embodiment, when the power of the transmission signal is less than the configured value, changing the signal path for the reception signal to the signal path in which the shunt capacitor 1510 is disposed may be robust to desense but may reduce absolute sensitivity. When the power of the transmission signal is equal to or greater than the configured value and the at least one reception signal satisfies the first condition, the electronic device 101 may use the signal path (e.g., the eighth transmission line 538) in which the shunt capacitor 1510 is disposed as the signal path for the reception signal satisfying the first condition.

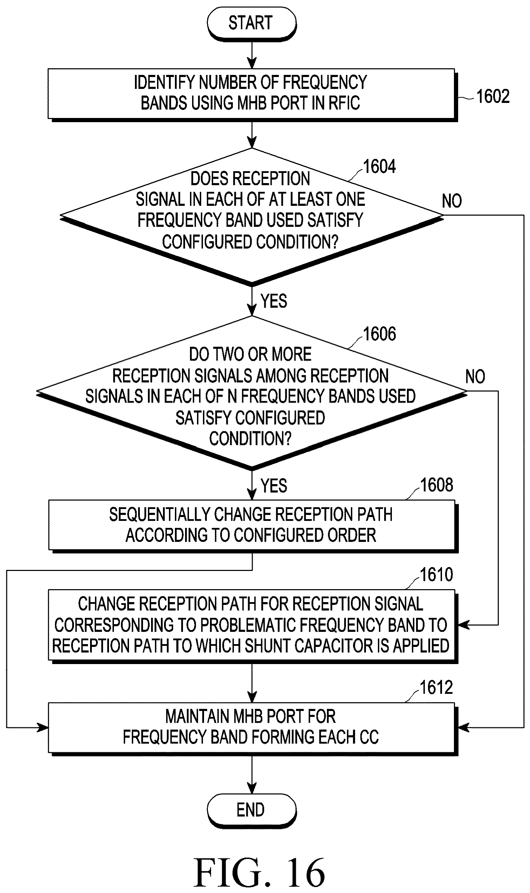

FIG. 16 is a flowchart illustrating an operating method of an electronic device (e.g., electronic device 101) according to various embodiments.

Referring to FIG. 16, according to various embodiments, the electronic device 101 may include an FPCB 530 electrically connected to an RFIC 410 and an RFFE 522 therebetween. The FPCB 530 may include RF transmission lines (e.g., a fifth transmission line 535 to an eighth transmission line 538) corresponding to four reception paths. However, the electronic device 101 may have other suitable components to realize functions and/or operations described herein.

According to an embodiment, in operation 1602, the electronic device 101 may identify the number of frequency bands using a reception path corresponding to MHB in the RFIC 410. For example, the number (N) of frequency bands using the reception path corresponding to the MHB may be 1 to 4 but is not limited thereto.

According to an embodiment, in operation 1604, the electronic device 101 may identify whether a reception signal in each frequency band used satisfies a configured condition (e.g., a first condition). For example, in operation 1604, the electronic device 101 may identify whether the SINR of the reception signal in each frequency band used is less than a reference SINR per MCS (e.g., as exemplarily shown in Table 1).

According to an embodiment, when the reception signal in each frequency band does not satisfy the configured condition (e.g., the first condition) (No in operation 1604), reception signals in each of all frequency bands are in a good state, and thus the electronic device 101 may control maintenance of a current signal path (e.g., the MHB port) for the frequency band forming each CC in operation 1612.

According to an embodiment, when the reception signal in each frequency band satisfies the configured condition (e.g., the first condition) (Yes in operation 1604), the electronic device 101 may identify whether two or more signal paths among the reception signals in each of the N frequency bands used satisfy the configured condition in operation 1606. As a result of identification, when the two or more signal paths satisfy the configured condition (Yes in operation 1606), the electronic device 101 may sequentially change the signal path for the reception signal in each frequency band according to a configured order until the two or more signal paths do not satisfy the configured condition in operation 1608. As a result of identification, when the two or more signal paths do not satisfy the configured condition (No in operation 1606), for example, when there is one problematic frequency band, the electronic device 101 may change a signal path for a reception signal corresponding to the problematic frequency band to a signal path (e.g., the eighth transmission line 538) to which a shunt capacitor is applied in operation 1610. In operation 1612, the electronic device 101 may control maintenance of the current signal path (e.g., the MHB port) for the frequency band forming each CC.

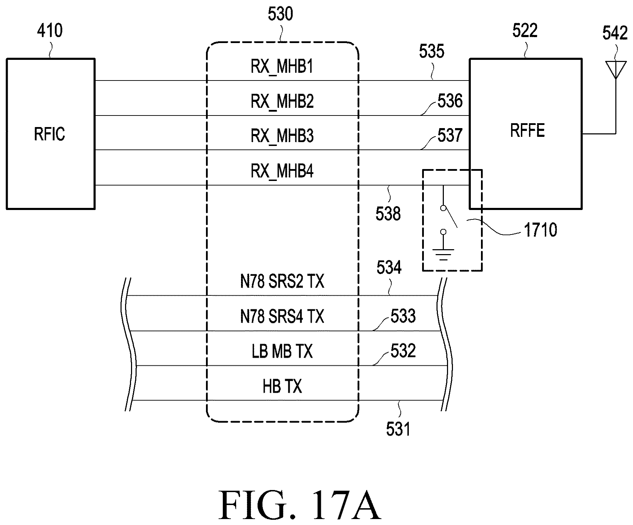

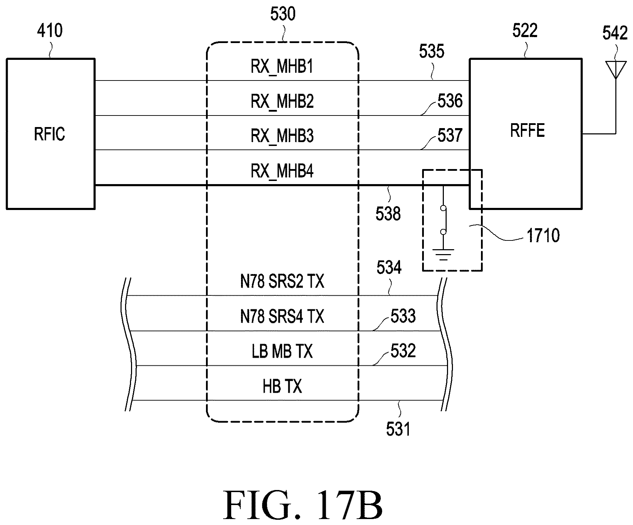

FIG. 17A and FIG. 17B are block diagrams of an electronic device (e.g., electronic device 101) according to various embodiments.

Referring to FIG. 17A and FIG. 17B, the electronic device 101 may add a ground switch 1710 to at least one RF transmission line (e.g., an eighth transmission line 538) among a plurality of RF transmission lines. According to an embodiment, when using the RF transmission line (e.g., the eighth transmission line 538) to which the ground switch 1710 is added in the current CA combination, the electronic device 101 may control the ground switch 1710 to be in an off state in FIG. 17A. According to an embodiment, when not using the RF transmission line (e.g., the eighth transmission line 538) to which the ground switch 1710 is added in the current CA combination, the electronic device 101 may change the ground switch 1710 from the off state in FIG. 17A to an on state in FIG. 17B, thereby short-circuiting the eighth transmission line 528 and a GND. As the eighth transmission line 528 is short-circuited with the GND, desense may be improved. For example, when the electronic device 101 transmits a transmission signal through at least one of a third transmission line 533 or a fourth transmission line 534 while transmitting a reception signal through a seventh transmission line 537 adjacent to the eighth transmission line 538, the electronic device 101 may control the ground switch 1710 to be in the on state, thereby improving, for example, desense. According to an embodiment, the ground switch 1710 may be disposed adjacent to the RFFE 522 (e.g., between the FPCB 530 and the RFFE 522) to enhance, for example, a desense reduction effect.

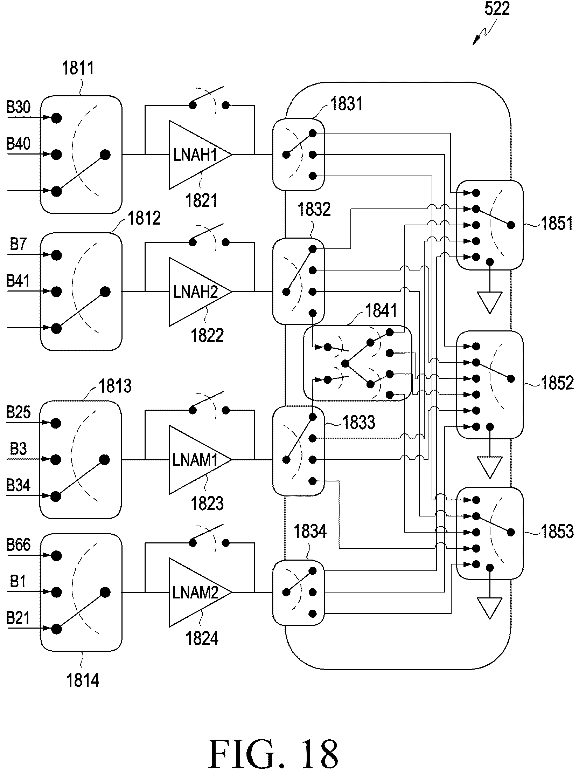

FIG. 18 is a block diagram of an electronic device (e.g., electronic device 101) according to various embodiments.

Referring to FIG. 18, an RFFE 522 (e.g., an RFFE circuit of the electronic device) may include a plurality of first switches 1811, 1812, 1813, and 1814, a plurality of LNAs 1821, 1822, 1823, and 1824, a plurality of second switches 1831, 1832, 1833, and 1834, a third switch 1841, and a plurality of fourth switches 1851, 1852, and 1853.

According to an embodiment, the plurality of first switches 1811, 1812, 1813, and 1814 may be connected to the plurality of LNAs 1821, 1822, 1823, and 1824, respectively. For example, a reception signal in a frequency band selected in each of the plurality of first switches 1811, 1812, 1813, and 1814 may be input to a corresponding LNA of the connected LNA 1821, 1822, 1823, and 1824 and subjected to low-noise amplification. The reception signal having subjected to low-noise amplification in each of the LNAs 1821, 1822, 1823, and 1824 may be transmitted to at least one of the plurality of fourth switches 1851, 1852, and 1853 according to control of the plurality of second switches 1831, 1832, 1833, and 1834 and the third switch 1841.

According to an embodiment, the plurality of fourth switches 1851, 1852, and 1853 may be connected to at least one RF transmission line among a plurality of RF transmission lines (e.g., a fifth transmission line 535 to an eighth transmission line 538) included in an FPCB 530. According to an embodiment, when a reception signal is not transmitted through an RF transmission line corresponding to a fourth switch among the plurality of fourth switches 1851, 1852, and 1853 through a corresponding RF transmission line, the fourth switch may be switched to be connected to a ground (GND). For example, when at least one fourth switch among the plurality of fourth switches 1851, 1852, and 1853 is connected to the ground (GND), the same effect as when the ground switch 1710 illustrated in FIG. 17B is controlled to be on may be achieved.

According to an embodiment, the electronic device 101 may store the foregoing reception path configuration order in the form of a lookup table. The electronic device 101 may update the lookup table through an artificial intelligence model based on a machine learning or deep learning model. Input variables of machine learning may include at least one of a transmission/reception frequency, a transmission/reception frequency band, transmission power, reception power, a selected transmission/reception path, or a reception sensitivity index (SIR, SINR, BLER, or BER). According to an embodiment, the position of the electronic device 101 may also be used for learning of the machine learning. The electronic device 101 may also consider the position when switching an RF transmission line. An output value of the machine learning may correspond to a selected transmission path and/or reception path. The machine learning model of the disclosure may include various transformer models. The operation of the machine learning model of the disclosure may include a learning and inference process of finding a pattern from data, storing the pattern as a model, which is a generalized rule, and inputting new data into the learned model to obtain a result. Learning of the machine learning model performed through the electronic device 101 may correspond to initial learning or may correspond to relearning. A learning process of the machine learning model may include forward propagation and/or backward propagation. An algorithm, such as "regression", "decision tree", "neural network", or "k-nearest neighbor", may be used for learning. According to various embodiments, a plurality of different machine learning models may be used for each target task.

The artificial intelligence model of the disclosure may be located in the memory of the electronic device 101, or at least some elements may be located in another electronic device 102 or 104 or a server 108.

The artificial intelligence model may include a plurality of artificial neural network layers. An artificial neural network may be one of a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of at least two thereof but is not limited to the foregoing examples. The artificial intelligence model may additionally or alternatively include a software structure in addition to a hardware structure.

According to an embodiment, the electronic device 101 may change the order of indexes stored in the lookup table by learning through the artificial intelligence model. For example, the electronic device 101 may update the lookup table by arranging recently used indexes relatively in the front or based on improvement rate (performance improvement) according to a combination.

According to an embodiment, an electronic device (e.g., the electronic device 101 as illustrated exemplarily in FIG. 5) may include a first printed circuit board (PCB) (e.g., the first PCB 510 as illustrated exemplarily in FIG. 5) including a radio frequency integrated circuit (RFIC) (e.g., the RFIC 420 as illustrated exemplarily in FIG. 5). The electronic device may include a second PCB (e.g., the second PCB 520 as illustrated exemplarily in FIG. 5) including a radio frequency front end (RFFE) circuit connected to at least one antenna. The electronic device may include at least one flexible PCB (FPCB) (e.g., the FPCB 530 as illustrated exemplarily in FIG. 5) including a plurality of transmission lines (e.g., the RF transmission lines 531, 532, 533, 534, 535, 536, 537, and 538 as illustrated exemplarily in FIG. 5) including a first radio frequency (RF) transmission line, a second RF transmission line, and a third RF transmission line, and connected to the first PCB and the second PCB therebetween. The electronic device may include memory (e.g., the memory 130 as illustrated exemplarily in FIG. 1) storing instructions. The electronic device may include at least one processor. The instructions, when executed by the at least one processor individually or collectively, may cause the electronic device to transmit transmission (Tx) signals from the first PCB to the second PCB through the first RF transmission line. The instructions, when executed by the at least one processor individually or collectively, may cause the electronic device to control transmission of first reception (Rx) signals, received via the at least one antenna, from the second PCB to the first PCB through the second RF transmission line. The instructions, when executed by the at least one processor individually or collectively, may cause the electronic device to identify information related to a quality of the first reception signals transmitted through the second RF transmission line while transmitting the transmission signals through the first RF transmission line. The instructions, when executed by the at least one processor individually or collectively, may cause the electronic device to control change of a signal path of the first reception signals from the second RF transmission line to the third RF transmission line, based on the information related to the quality of the first reception signals satisfying a first condition.

According to an embodiment, the instructions, when executed by the at least one processor individually or collectively, may cause the electronic device to control maintenance of the transmission of the first reception signals through the second RF transmission line, based on the information related to the quality of the first reception signals satisfying a second condition.

According to an embodiment, the second condition may correspond to a pass condition, and the first condition may correspond to a fail condition.

According to an embodiment, the RFFE circuit may (e.g., additionally) include a switch, and the instructions, when executed by the at least one processor individually or collectively, may cause the electronic device to control the change of the signal path of the first reception signals by the switch.

According to an embodiment, a first frequency band corresponding to the transmission signals is higher than a second frequency band corresponding to the first reception signals.

According to an embodiment, the instructions, when executed by the at least one processor individually or collectively, may cause the electronic device to control transmission of second reception signals corresponding to a third frequency band forming carrier aggregation together with the first reception signals corresponding to the second frequency band from the second PCB to the first PCB through the third RF transmission line, and control exchange of the signal path of the first reception signals and a signal path of the second reception signals, based on the information related to the quality of the first reception signals satisfying the first condition.

According to an embodiment, the instructions, when executed by the at least one processor individually or collectively, may cause the electronic device to identify the third RF transmission line which is currently not used from among the plurality of transmission lines, based on the information related to the quality of the first reception signals satisfying the first condition, and control the change of the signal path of the first reception signals from the second RF transmission line to the third RF transmission line.

According to an embodiment, the instructions, when executed by the at least one processor individually or collectively, may cause the electronic device to control transmission of a plurality of reception signals forming carrier aggregation, respectively, from the second PCB to the first PCB through the plurality of transmission lines, and control change of a combination of the plurality of reception signals and the plurality of transmission lines sequentially, based on information related to a quality of at least one reception signal of the plurality of reception signals satisfying the first condition.

According to an embodiment, the instructions, when executed by the at least one processor individually or collectively, may cause the electronic device to control maintenance of the combination of the plurality of reception signals and the plurality of transmission lines, based on the information related to the quality of the reception signal of the plurality of reception signals satisfying the second condition.

According to an embodiment, the information related to the quality of the first reception signal may include at least one of a reference signal received power (RSRP), a received signal strength indicator (RSSI), a reference signal received quality (RSRQ), a signal-to-interference plus noise ratio (SINR), or a signal-to-noise ratio (SNR).

According to an embodiment, the instructions, when executed by the at least one processor individually or collectively, may cause the electronic device to control maintenance of the combination of the plurality of Rx signals and the plurality of RF transmission lines, based on information related to the quality of the plurality of Rx signals satisfying the second condition.

According to an embodiment, the Tx signals corresponds to a control signal, and the Rx signals corresponds to a data signal.

According to an embodiment, the control signal corresponds to one of a plurality of control signals being transmitted for identifying a state of an uplink channel, and a first power value of the control signal is adjusted to be increased in consideration of a second power value of another control signal of the plurality of control signals.

According to various embodiments, an operating method of an electronic device including a first printed circuit board (PCB) including a radio frequency integrated circuit (RFIC), a second PCB including a radio frequency front end (RFFE) circuit connected to the RFIC and at least one antenna therebetween, at least one flexible PCB (FPCB) including a plurality of transmission lines including a first radio frequency (RF) transmission line, a second RF transmission line, and a third RF transmission line, and connected to the first PCB and the second PCB therebetween, and at least one processor may include transmitting transmission (Tx) signals from the first PCB to the second PCB through the first RF transmission line. The operating method of the electronic device may include controlling transmission of first reception (Rx) signals, received via the at least one antenna, from the second PCB to the first PCB through the second RF transmission line. The operating method of the electronic device may include identifying information related to a quality of the first reception signals transmitted through the second RF transmission line while transmitting the transmission signals through the first RF transmission line. The operating method of the electronic device may include controlling change of a signal path of the first Rx signals from the second RF transmission line to the third RF transmission line, based on the information related to the quality of the first Rx signals satisfying a first condition.

According to an embodiment, the method may include controlling maintenance of the transmission of the first reception signals through the second RF transmission line, based on the information related to the quality of the first reception signals satisfying a second condition.

According to an embodiment, the second condition may correspond to a pass condition, and the first condition may correspond to a fail condition.

According to an embodiment, the RFFE circuit may (e.g., additionally) include a switch, and the method may include controlling the change of the signal path of the first reception signals by the switch.

According to an embodiment, the RFFE circuit may include a plurality of switches, and the method may include controlling the change of the signal path of the first reception signals by setting (e.g., switching) the plurality switches. According to an embodiment, the RFFE circuit may be coupled to the plurality of transmission lines through a plurality of switches, and the method may include controlling the change of the signal path of the first reception signals by setting (e.g., switching) the plurality switches.

According to an embodiment, a first frequency band corresponding to the transmission signals is higher than a second frequency band corresponding to the first reception signals.

According to an embodiment, the method may include controlling transmission of second reception signals corresponding to a third frequency band forming carrier aggregation together with the first reception signals corresponding to a second frequency band from the second PCB to the first PCB through the third RF transmission line, and controlling exchange of the signal path of the first reception signals and a signal path of the second reception signals, based on the information related to the quality of the first reception signals satisfying the first condition.

According to an embodiment, the method may include identifying the third RF transmission line which is currently not used from among the plurality of transmission lines, based on the information related to the quality of the first reception signals satisfying the first condition, and controlling the change of the signal path of the first reception signals from the second RF transmission line to the third RF transmission line.

According to an embodiment, the method may include controlling transmission of a plurality of reception signals including the first reception signals forming carrier aggregation from the second PCB to the first PCB respectively through the plurality of transmission lines, and controlling change of a combination of the plurality of reception signals and the plurality of transmission lines sequentially, based on information related to a quality of at least one reception signal of the plurality of reception signals satisfying the first condition.

According to an embodiment, the method may include controlling maintenance of the combination of the plurality of Rx signals and the plurality of transmission lines, based on the information related to the quality of the Rx signal of the plurality of Rx signals satisfying the second condition.

According to an embodiment, the information related to the quality of the first reception signal may include at least one of a reference signal received power (RSRP), a received signal strength indicator (RSSI), a reference signal received quality (RSRQ), a signal-to-interference plus noise ratio (SINR), or a signal-to-noise ratio (SNR).

According to an embodiment, the Tx signals corresponds to a control signal, and the Rx signals corresponds to a data signal.

According to various embodiments, a computer-readable storage medium may store at least one instruction which, when executed by a processor of an electronic device individually or collectively, cause the electronic device to perform at least one operation. The at least one operation may include an operation of transmitting transmission (Tx) signals from the first PCB to the second PCB through a first RF transmission line among a plurality of transmission lines disposed on a flexible printed circuit board (PCB) connecting a first PCB including a radio frequency integrated circuit (RFIC) and a second PCB including a radio frequency front end (RFFE) circuit connected to the RFIC and at least one antenna therebetween. The at least one operation may include an operation of controlling transmission of first reception (Rx) signals, received via the at least one antenna, from the second PCB to the first PCB through a second RF transmission line among the plurality of transmission lines. The at least one operation may include an operation of identifying information related to a quality of the first reception signals transmitted through the second RF transmission line while transmitting the transmission signals through the first RF transmission line. The at least one operation may include an operation of controlling change of a signal path of the first reception signals from the second RF transmission line to a third RF transmission line among the plurality of transmission lines, based on the information related to the quality of the first reception signals satisfying a first condition.

According to various embodiments, an electronic device may include a first printed circuit board (PCB) including a radio frequency integrated circuit (RFIC). The electronic device may include a second PCB including a radio frequency front end (RFFE) circuit connected to at least one antenna. The electronic device may include at least one flexible PCB (FPCB) including a plurality of transmission lines including a first RF transmission line, a second RF transmission line, and a third RF transmission line, and connected to the first PCB and the second PCB therebetween. The electronic device may include memory storing instructions. The electronic device may include at least one processor. The instructions, when executed by the at least one processor individually or collectively, may cause the electronic device to transmit transmission (Tx) signals from the first PCB to the second PCB through the first RF transmission line. The instructions, when executed by the at least one processor individually or collectively, may cause the electronic device to control transmission of first reception (Rx) signals, received via the at least one antenna, from the second PCB to the first PCB through the second RF transmission line. The instructions, when executed by the at least one processor individually or collectively, may cause the electronic device to identify a magnitude of the transmission signals transmitted through the first RF transmission line while transmitting the transmission signals through the first RF transmission line. The instructions, when executed by the at least one processor individually or collectively, may cause the electronic device to control change of a signal path of the first reception signals from the second RF transmission line to the third RF transmission line, based on the magnitude of the transmission signals satisfying a first condition.

According to an embodiment, the instructions, when executed by the at least one processor individually or collectively, may cause the electronic device to maintain transmission of the first reception signals through the second RF transmission line, based on the magnitude of the transmission signals satisfying a second condition.

According to an embodiment, the second condition may correspond to a pass condition, and the first condition may correspond to a fail condition.

According to an embodiment, the RFFE circuit may (e.g., additionally) include a switch, and the instructions, when executed by the at least one processor individually or collectively, may cause the electronic device to control the change of the signal path of the first reception signals by the switch.

According to an embodiment, the instructions, when executed by the at least one processor individually or collectively, may cause the electronic device to control transmission of second Rx signals forming carrier aggregation together with the first Rx signals from the second PCB to the first PCB through the third RF transmission line while transmitting the first Rx signals to the first PCB, and control exchange of a signal path of the second Rx signals from the third RF transmission line to the second RF transmission line, based on information related to the magnitude of the transmission signals satisfying the a specified condition.

According to an embodiment, the instructions, when executed by the at least one processor individually or collectively, may cause the electronic device to identify the third RF transmission line which is currently not used from among the plurality of transmission lines, based on information related to the magnitude of the transmission signals satisfying the specified condition, and control the change of the signal path of the first Rx signals from the second RF transmission line to the third RF transmission line.

According to an embodiment, the electronic device (e.g., additionally) includes a capacitor connected to the third RF transmission line and a ground therebetween. According to an embodiment, the electronic device (e.g., additionally) includes a switch connected to the third RF transmission line and a ground therebetween.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a first printed circuit board(PCB)comprising a radio frequency integrated circuit(RFIC);
a second PCB comprising a radio frequency front end(RFFE) circuit connected to at least one antenna;
at least one flexible PCB(FPCB)comprising a plurality of transmission lines comprising a first RF transmission line, a second RF transmission line, and a third RF transmission line, the at least one FPCB being connected to the first PCB and the second PCB therebetween;
memory storing instructions; and
at least one processor,
wherein the instructions, when executed by the at least one processor individually or collectively, cause the electronic device to:
transmit transmission(Tx) signals through the first RF transmission line from the first PCB to the second PCB;
control transmission of first reception(Rx) signals, received via the at least one antenna, through the second RF transmission line from the second PCB to the first PCB;
while transmitting the Tx signals through the first RF transmission line, identify information related to a quality of the first Rx signals transmitted through the second RF transmission line; and
based on the information related to the quality of the first Rx signals satisfying a first condition, control change of a signal path of the first Rx signals from the second RF transmission line to the third RF transmission line.

2. The electronic device of claim 1, wherein the instructions, when executed by the at least one processor individually or collectively, cause the electronic device to:
based on the information related to the quality of the first Rx signals satisfying a second condition, control maintenance of the transmission of the first Rx signals through the second RF transmission line.

3. The electronic device of claim 2, wherein the second condition corresponds to a pass condition, and the first condition corresponds to a fail condition.

4. The electronic device of claim 1, wherein the RFFE circuit further comprises a switch, and
wherein the instructions cause the electronic device to:
control the change of the signal path of the first Rx signals by the switch.

5. The electronic device of claim 1, wherein a first frequency band corresponding to the Tx signals is higher than a second frequency band corresponding to the first Rx signals.

6. The electronic device of any one of claims 1 to 5, wherein the instructions, when executed by the at least one processor individually or collectively, cause the electronic device to:
control transmission of second Rx signals corresponding to a third frequency band forming carrier aggregation together with the first Rx signals corresponding to a second frequency band from the second PCB to the first PCB through the third RF transmission line; and
based on the information related to the quality of the first Rx signals satisfying the first condition, control exchange of the signal path of the first Rx signals and a signal path of the second Rx signals.

7. The electronic device of any one of claims 1 to 5, wherein the instructions, when executed by the at least one processor individually or collectively, cause the electronic device to:
based on the information related to the quality of the first Rx signals satisfying the first condition, identify the third RF transmission line which is currently not used from among the plurality of transmission lines; and
control the change of the signal path of the first Rx signals from the second RF transmission line to the third RF transmission line.

8. The electronic device of any one of claims 1 to 5, wherein the instructions, when executed by the at least one processor individually or collectively, cause the electronic device to:
control transmission of a plurality of Rx signals constituting carrier aggregation together from the second PCB to the first PCB respectively through the plurality of transmission lines; and
based on information related to the quality of at least one of the plurality of Rx signals satisfying the first condition, control change of a combination of the plurality of Rx signals and the plurality of transmission lines sequentially.

9. The electronic device of claim 8, wherein the instructions, when executed by the at least one processor individually or collectively, cause the electronic device to:
based on information related to the quality of the plurality of Rx signals satisfying the second condition, control maintenance of the combination of the plurality of Rx signals and the plurality of transmission lines.

10. The electronic device of any one of claims 1 to 9, wherein the Tx signals corresponds to a control signal, and the first Rx signals corresponds to a data signal.

11. The electronic device of claim 10, wherein the control signal corresponds to one of a plurality of control signals being transmitted for identifying a state of a channel, and a first power value of the control signal is adjusted to be increased in consideration of a second power value of another control signal of the plurality of control signals.

12. An operating method of an electronic device comprising a first printed circuit board(PCB) comprising a radio frequency integrated circuit(RFIC), a second PCB comprising a radio frequency front end(RFFE) circuit connected to the RFIC and at least one antenna therebetween, at least one flexible PCB(FPCB) comprising a plurality of transmission lines comprising a first radio frequency(RF) transmission line, a second RF transmission line, and a third RF transmission line, and connected to the first PCB and the second PCB therebetween, and at least one processor, the method comprising:
transmitting transmission(Tx) signals through the first RF transmission line from the first PCB to the second PCB;
controlling transmission of first reception(Rx) signals, received via the at least one antenna, through the second RF transmission line from the second PCB to the first PCB;
identifying information related to a quality of the first Rx signals transmitted through the second RF transmission line while transmitting the Tx signals through the first RF transmission line; and
controlling change of a signal path of the first Rx signals from the second RF transmission line to the third RF transmission line, based on the information related to the quality of the first Rx signals satisfying a first condition.

13. The method of claim 12, comprising:
controlling maintenance of the transmission of the first Rx signals through the second RF transmission line, based on the information related to the quality of the first Rx signals satisfying a second condition.

14. The method of claim 13, wherein the second condition corresponds to a pass condition, and the first condition corresponds to a fail condition.

15. A non-transitory computer-readable storage medium storing at least one instruction which, when executed by at least one processor of an electronic device individually or collectively, cause the electronic device to perform at least one operation, the at least one operation comprising:
an operation of transmitting transmission(Tx) signals from the first PCB to the second PCB through a first RF transmission line among a plurality of transmission lines disposed on a flexible printed circuit board(PCB) connecting a first PCB comprising a radio frequency integrated circuit(RFIC) and a second PCB comprising a radio frequency front end(RFFE) circuit connected to the RFIC and at least one antenna therebetween;
an operation of controlling transmission of first reception(Rx) signals, received via the at least one antenna, from the second PCB to the first PCB through a second RF transmission line among the plurality of transmission lines;
an operation of identifying information related to a quality of the first Rx signals transmitted through the second RF transmission line while transmitting the Tx signals through the first RF transmission line; and
an operation of controlling change of a signal path of the first Rx signals from the second RF transmission line to a third RF transmission line among the plurality of transmission lines, based on the information related to the quality of the first Rx signals satisfying a first condition.
